# EUROPEAN PATENT APPLICATION

(11) **EP 4 456 116 A1**
(43) Date of publication of application: **30.10.2024**
(21) Application number: 24171513.5
(22) Date of filing: 22.04.2024
(51) Int. Cl.: H01L 21/02, H10B 43/27, H10B 43/30

(54) **SEMICONDUCTOR STORAGE DEVICE AND METHOD OF MANUFACTURING SEMICONDUCTOR STORAGE DEVICE**

(30) Priority: 26.04.2023 JP 2023072292
(71) Applicant: Kioxia Corporation, Tokyo 108-0023 (JP)
(72) Inventor: Matsushita, Takumi, Tokyo, 108-0023 (JP); Ishihara, Noritaka, Tokyo, 108-0023 (JP); Uejima, Kazuya, Tokyo, 108-0023 (JP)
(74) Representative: Marks & Clerk LLP

(57) **Abstract**

A semiconductor storage device (1) according to an embodiment includes a stacked body (LM) including a plurality of conductive layers (WL, SGD, SGS) and a plurality of insulating layers (OL) alternately stacked, and a plurality of pillars (PL) each including a core material (CR) extending in the stacked body (LM) in a first direction intersecting a face of each of the plurality of conductive layers (WL, SGD, SGS), a semiconductor layer (CN) covering a side face of the core material (CR), and a multi-layered insulating layer (ME) stacked on a side face of the semiconductor layer (CN), the semiconductor layer (CN) being crystalline, the multi-layered insulating layer (ME) including a charge storage layer (CT), wherein each of the semiconductor layers (CN) includes a crystal structure in which the appearance number of crystal grain boundaries per 1 µm in the first direction is less than 2 near to at least a first end in the first direction, and an additive that includes one or more of carbon, nitrogen, oxygen, and fluorine.

## Description

### CROSS-REFERENCE TO RELATED APPLICATIONS

This application is based upon and claims the benefit of priority from Japanese Patent Application No. 2023-072292, filed on April 26, 2023; the entire contents of which are incorporated herein by reference.

### FIELD

Embodiments described herein relate generally to a semiconductor storage device and a method of manufacturing the semiconductor storage device.

### BACKGROUND

In the three-dimensional nonvolatile memory, for example, a pillar having a semiconductor layer serving as a channel layer and a multi-layered insulating layer serving as a memory layer in a stacked body in which a plurality of conductive layers is stacked is penetrated. The semiconductor layer to be the channel layer is preferably single crystallized over the entire pillar extension direction. As a result, the resistance of the channel layer can be reduced, and the noise derived from the channel layer can be reduced, and the electrical characteristics of the memory cell formed at the intersection with the plurality of conductive layers can be improved.

### BRIEF DESCRIPTION OF THE DRAWINGS

Fig. 1 is a block diagram of a semiconductor storage device according to an embodiment;
Fig. 2 is an equivalent circuit diagram illustrating an example of a configuration of a memory cell array included in the semiconductor storage device according to the embodiment;
Fig. 3 is a cross-sectional view illustrating a schematic configuration example of the semiconductor storage device according to the embodiment;
Figs. 4A to 4D are diagrams illustrating an example of a configuration of the semiconductor storage device according to the embodiment;
Figs. 5A to 5C are schematic diagrams illustrating a crystal structure of a channel layer included in a plurality of pillars of the semiconductor storage device according to the embodiment;
Figs. 6A to 6C are diagrams sequentially illustrating part of the procedure of the method of manufacturing the semiconductor storage device according to the embodiment;
Figs. 7A to 7C are diagrams sequentially illustrating part of the procedure of the method of manufacturing the semiconductor storage device according to the embodiment;
Figs. 8A to 8F are diagrams sequentially illustrating part of the procedure of the method of manufacturing the semiconductor storage device according to the embodiment;
Figs. 9A to 9C are diagrams sequentially illustrating part of the procedure of the method of manufacturing the semiconductor storage device according to the embodiment;
Figs. 10A and 10B are diagrams sequentially illustrating part of the procedure of the method of manufacturing the semiconductor storage device according to the embodiment;
Figs. 11A to 11F are diagrams sequentially illustrating part of the procedure of the method of manufacturing the semiconductor storage device according to the embodiment;
Figs. 12A to 12F are diagrams sequentially illustrating part of the procedure of the method of manufacturing the semiconductor storage device according to the embodiment;
Figs. 13A to 13F are diagrams sequentially illustrating part of the procedure of the method of manufacturing the semiconductor storage device according to the embodiment;
Figs. 14A to 14C are enlarged cross-sectional views of a memory hole illustrating a state in which an amorphous channel layer according to a comparative example is converted into a crystalline channel layer;
Fig. 15 is a graph illustrating an appropriate position of a doped layer introduced into a channel layer according to the embodiment;
Figs. 16A to 16C are enlarged cross-sectional views sequentially illustrating part of the procedure of the method of manufacturing the semiconductor storage device according to the modification of the embodiment;
Figs. 17A to 17C are enlarged cross-sectional views sequentially illustrating part of the procedure of the method of manufacturing the semiconductor storage device according to a modification of the embodiment; and
Fig. 18 is a cross-sectional view illustrating an example of a configuration of a semiconductor storage device according to another modification of the embodiment.

### DETAILED DESCRIPTION

A semiconductor storage device according to an embodiment includes a stacked body including a plurality of conductive layers and a plurality of insulating layers alternately stacked, and a plurality of pillars each including a core material extending in the stacked body in a first direction intersecting a face of each of the plurality of conductive layers, a semiconductor layer covering a side face of the core material, and a multi-layered insulating layer stacked on a side face of the semiconductor layer, the semiconductor layer being crystalline, the multi-layered insulating layer including a charge storage layer, wherein each of the semiconductor layers includes a crystal structure in which the appearance number of crystal grain boundaries per 1 µm in the first direction is less than 2 near to at least a first end in the first direction, and an additive that includes one or more of carbon, nitrogen, oxygen, and fluorine.

Hereinafter, embodiments of the present invention will be described in detail with reference to the drawings. In addition, the present invention is not limited by the following embodiment. In addition, constituent elements in the following embodiments include those that can be easily assumed by those skilled in the art or those that are substantially the same.

### (Functional configuration of semiconductor storage device)

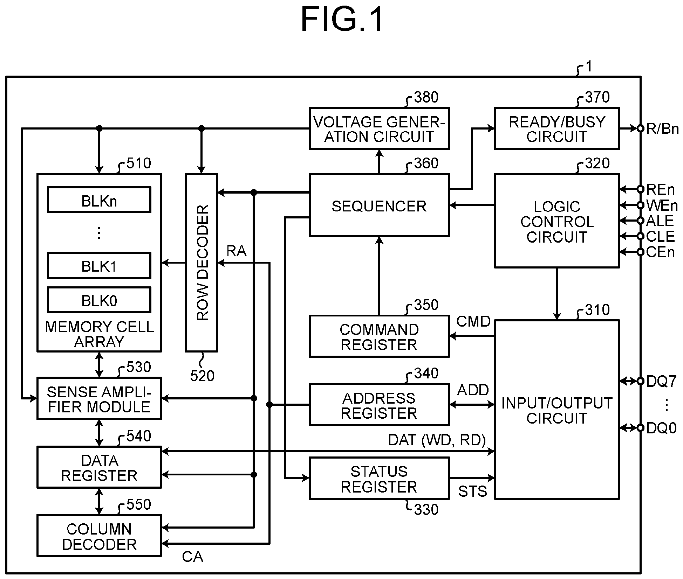

Fig. 1 is a block diagram of a semiconductor storage device 1 according to an embodiment. As illustrated in Fig. 1, the semiconductor storage device 1 includes an input/output circuit 310, a logic control circuit 320, a status register 330, an address register 340, a command register 350, a sequencer 360, a ready/busy circuit 370, a voltage generation circuit 380, a memory cell array 510, a row decoder 520, a sense amplifier module 530, a data register 540, and a column decoder 550.

The input/output circuit 310 controls input/output of a signal DQ with an external device such as a memory controller (not illustrated) that controls the semiconductor storage device 1. The input/output circuit 310 includes an input circuit and an output circuit (not illustrated).

The input circuit transmits data DAT such as write data WD received from the external device to the data register 540, transmits an address ADD to the address register 340, and transmits a command CMD to the command register 350.

The output circuit transmits status information STS received from the status register 330, the data DAT such as read data RD received from the data register 540, and the address ADD received from the address register 340 to the external device.

The logic control circuit 320 receives, for example, a chip enable signal CEn, a command latch enable signal CLE, an address latch enable signal ALE, a write enable signal WEn, and a read enable signal REn from an external device. In addition, the logic control circuit 320 controls the input/output circuit 310 and the sequencer 360 according to the received signal.

The status register 330 temporarily holds the status information STS in, for example, a write operation, a read operation, and an erase operation of data, and notifies the external device whether the operation is normally ended.

The address register 340 temporarily holds the address ADD received from the external device via the input/output circuit 310. In addition, the address register 340 transfers a row address RA to the row decoder 520 and transfers a column address CA to the column decoder 550.

The command register 350 temporarily stores the command CMD received from the external device via the input/output circuit 310 and transfers the command CMD to the sequencer 360.

The sequencer 360 controls the entire operation of the semiconductor storage device 1. More specifically, the sequencer 360 controls, for example, the status register 330, the ready/busy circuit 370, the voltage generation circuit 380, the row decoder 520, the sense amplifier module 530, the data register 540, the column decoder 550, and the like according to the command CMD held by the command register 350, and executes a write operation, a read operation, an erase operation, and the like.

The ready/busy circuit 370 transmits a ready/busy signal R/Bn to an external device according to the operation status of the sequencer 360.

The voltage generation circuit 380 generates a voltage necessary for the write operation, the read operation, and the erase operation according to the control of the sequencer 360, and supplies the generated voltage to, for example, the memory cell array 510, the row decoder 520, the sense amplifier module 530, and the like. The row decoder 520 and the sense amplifier module 530 apply the voltage supplied from the voltage generation circuit 380 to the memory cells in the memory cell array 510.

The memory cell array 510 includes a plurality of blocks BLK (BLK0 to BLKn). n is an integer of two or more. The block BLK is a set of a plurality of memory cells associated with bit lines and word lines, and is, for example, a data erasing unit. The memory cell is configured as, for example, a transistor, and holds nonvolatile data.

By including such a memory cell, the semiconductor storage device 1 is configured as, for example, a NAND nonvolatile memory.

The row decoder 520 decodes the row address RA. In addition, the row decoder 520 selects any block BLK based on the decoding result. The row decoder 520 applies a necessary voltage to the block BLK.

The sense amplifier module 530 senses data read from the memory cell array 510 during the read operation. In addition, the sense amplifier module 530 transmits the read data RD to the data register 540. During the write operation, the sense amplifier module 530 transmits the write data WD to the memory cell array 510.

The data register 540 includes a plurality of latch circuits. The latch circuit holds the write data WD and read data RRD. For example, in the write operation, the data register 540 temporarily holds the write data WD received from the input/output circuit 310 to transmit the write data WD to the sense amplifier module 530. In addition, for example, in the read operation, the data register 540 temporarily holds the read data RD received from the sense amplifier module 530 to transmit the read data RD to the input/output circuit 310.

The column decoder 550 decodes the column address CA at the time of, for example, the write operation, the read operation, and the erase operation, and selects the latch circuit in the data register 540 according to the decoding result.

Note that a circuit group disposed around the memory cell array 510 is also referred to as a peripheral circuit. The peripheral circuit includes at least the row decoder 520, the sense amplifier module 530, the data register 540, and the column decoder 550. The peripheral circuit may include the status register 330, the address register 340, the command register 350, and the sequencer 360, and may further include the input/output circuit 310, the logic control circuit 320, the ready/busy circuit 370, and the voltage generation circuit 380.

As described above, the semiconductor storage device 1 includes the memory cell array 510 including the plurality of memory cells and the peripheral circuit that operates the plurality of memory cells.

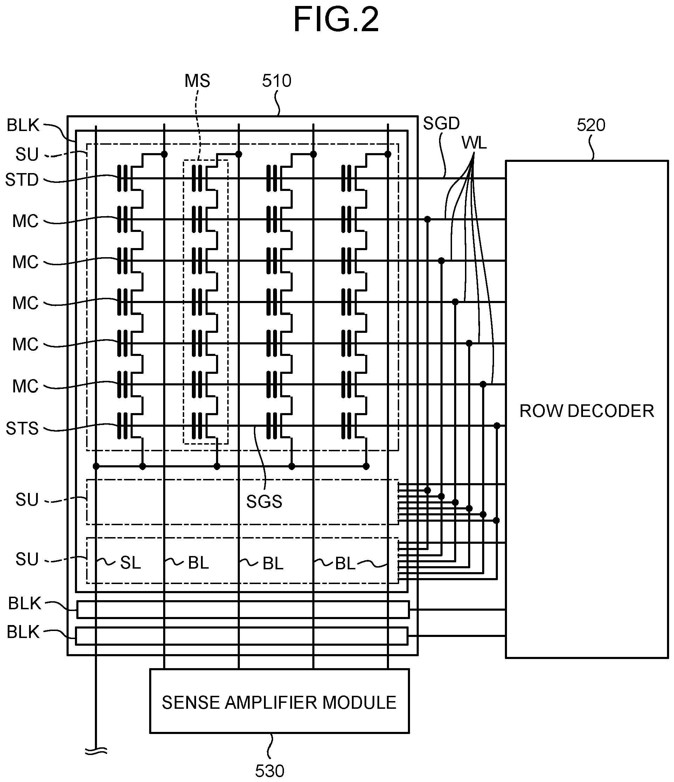

Fig. 2 is an equivalent circuit diagram illustrating an example of a configuration of the memory cell array 510 included in the semiconductor storage device 1 according to the embodiment.

The memory cell array 510 includes the plurality of blocks BLK as described above. Each of the plurality of blocks BLK includes a plurality of string units SU. Each of the plurality of string units SU includes a plurality of memory strings MS. One end of each of the plurality of memory strings MS is connected to a peripheral circuit such as the sense amplifier module 530 via a bit line BL. The other end of each of the plurality of memory strings MS is connected to a peripheral circuit via a common source line SL.

The memory string MS includes a drain selection transistor STD connected in series between the bit line BL and the source line SL, a plurality of memory cells MC, and a source selection transistor STS. Hereinafter, each of the drain selection transistor STD and the source selection transistor STS may be simply referred to as selection transistors (STD, STS).

The memory cell MC is, for example, a field effect transistor (FET) including a charge storage layer in a gate insulating layer. The threshold value voltage of the memory cell MC changes according to the charge amount in the charge storage layer. By providing one or a plurality of threshold value voltages, the memory cell MC may be capable of storing data of 1 bit or a plurality of bits. The word line WL is connected to the gate electrodes of the plurality of memory cells MC corresponding to one memory string MS. These word lines WL is commonly connected to all the memory strings MS in one block BLK.

The selection transistor (STD, STS) is, for example, a field effect transistor. A selection gate line (SGD, SGS) is connected to each gate electrode of the selection transistor (STD, STS). The drain selection line SGD connected to the drain selection transistor STD is provided corresponding to the string unit SU, and is commonly connected to all the memory strings MS in one string unit SU. The source selection line SGS connected to the source selection transistor STS is commonly connected to all the memory strings MS in one block BLK.

One end of each of the word line WL and the selection gate line (SGD, SGS) is connected to a peripheral circuit such as the row decoder 520.

### (Physical configuration of semiconductor storage device)

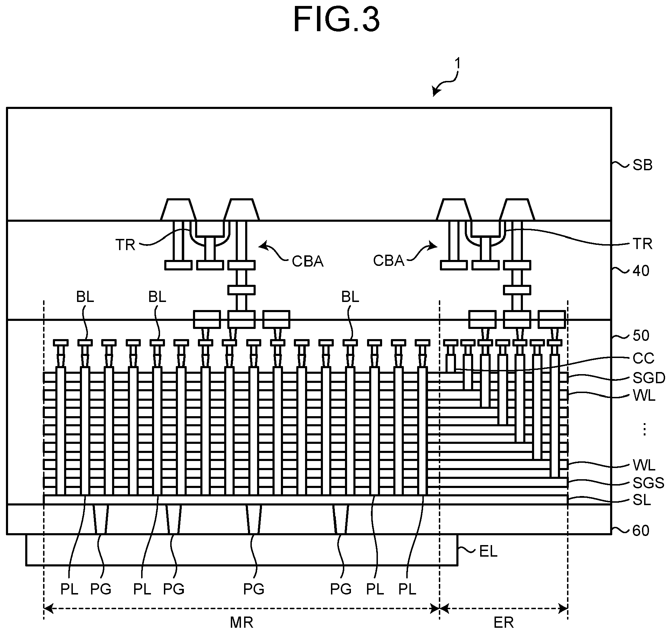

Fig. 3 is a cross-sectional view illustrating an example of a schematic physical configuration of the semiconductor storage device 1 according to the embodiment. However, in Fig. 3, hatching is omitted in consideration of visibility of the drawing.

As illustrated in Fig. 3, the semiconductor storage device 1 includes an electrode layer EL, a source line SL, a selection gate line SGD, a plurality of word lines WL, and a selection gate line SGS in order from the lower side of the drawing. In addition, the semiconductor storage device 1 includes a peripheral circuit CBA provided on a semiconductor substrate SB above the selection gate line SGD.

The source line SL is disposed above electrode layer EL with an insulating layer 60 interposed therebetween. A plurality of plugs PG is disposed in the insulating layer 60, and the source line SL and the electrode layer EL maintain electrical conduction via the plugs PG. As a result, the source potential can be applied from the above-described voltage generation circuit 380 (see Fig. 1) to the source line SL via the electrode layer EL and the plug PG.

One or more selection gate lines SGD, a plurality of word lines WL, and one or more selection gate lines SGS are stacked in this order on the source line SL. A memory region MR is disposed in the plurality of word lines WL and the like, and a contact region ER is disposed at an end in a direction in which the plurality of word lines WL extends.

In the memory region MR, a plurality of pillars PL penetrating the word line WL and the like in the stacking direction is disposed. A plurality of memory cells MC (see Fig. 2) is formed at intersections of the pillars PL and the word lines WL. As a result, the semiconductor storage device 1 is configured as, for example, a three-dimensional nonvolatile memory in which the memory cells MC are three-dimensionally disposed in the memory region MR.

As described above, the memory region MR is an example of a physical configuration corresponding to the above-described memory cell array 510 (see Fig. 2). In addition, the pillar PL is an example of a physical configuration corresponding to the above-described memory string MS (see Fig. 2) in which the memory cells MC and the like are connected in series.

In the physical configuration of the semiconductor storage device 1, the pillar PL is electrically connected to the peripheral circuit CBA via the bit line BL disposed above the pillar PL.

In the contact region ER, a plurality of contacts CC connected to the plurality of word lines WL and the selection gate lines SGD and SGS is disposed.

From the contact CC, a write voltage, a read voltage, and the like are applied to the memory cell MC included in the memory region MR at the center in the direction in which the plurality of word lines WL extends via the word line WL at the same height position as the memory cell MC. In this manner, the word lines WL and the selection gate lines SGD and SGS stacked in a plurality of layers are individually drawn from these contacts CC.

The plurality of word lines WL, the selection gate lines SGD and SGS, the pillars PL, and the contacts CC are covered with an insulating layer 50. The insulating layer 50 also extends around the plurality of word lines WL and the like.

The semiconductor substrate SB above the insulating layer 50 is, for example, a silicon substrate or the like. The peripheral circuits CBA such as the above-described row decoder 520 including the transistor TR, wiring, and the like and the sense amplifier module 530 (see Fig. 1) are disposed on the surface of the semiconductor substrate SB. Various voltages applied from the contacts CC to the memory cells MC are controlled by peripheral circuits CBA electrically connected to the contacts CC. In addition, data read from the memory cells MC disposed in the height direction of the pillars PL is read to the sense amplifier module 530 of the peripheral circuit CBA. In this manner, the peripheral circuit CBA controls the electrical operation of the memory cell MC.

The peripheral circuit CBA is covered with an insulating layer 40, and the insulating layer 40 and the insulating layer 50 covering the plurality of word lines WL and the like are joined to configure the semiconductor storage device 1 including the configurations of the plurality of word lines WL and the selection gate lines SGD and SGS, the pillars PL, the contacts CC, and the like, and the peripheral circuit CBA.

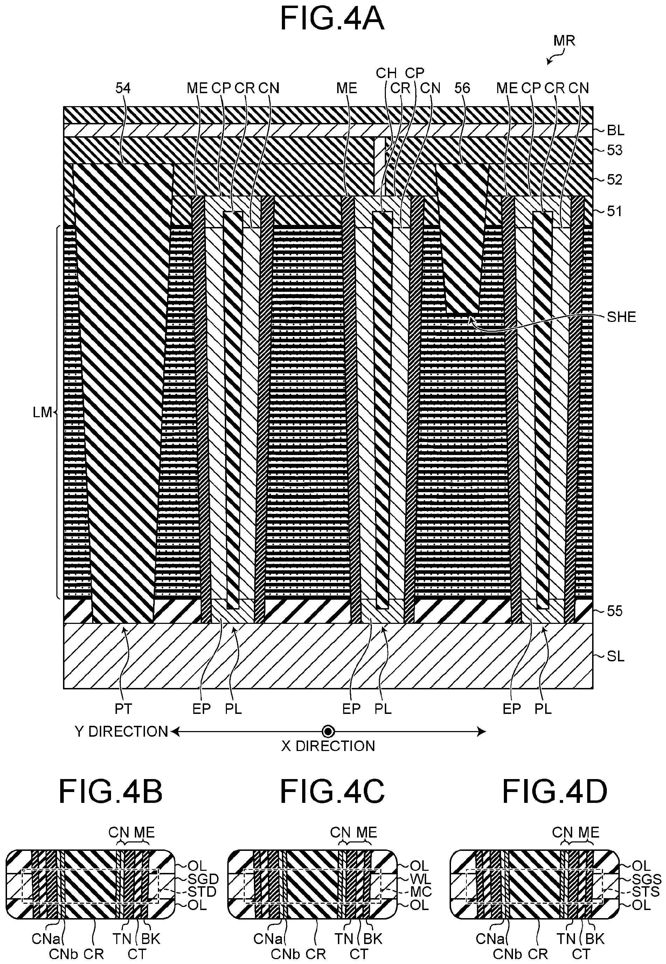

Next, a detailed configuration example of the semiconductor storage device 1 will be described with reference to Figs. 4A to 5C.

Figs. 4A to 4D are diagrams illustrating an example of a configuration of the semiconductor storage device 1 according to the embodiment.

More specifically, Fig. 4A is a cross-sectional view of the semiconductor storage device 1 along the Y direction, the semiconductor storage device 1 including the memory region MR. In Fig. 4A, structures of layers above an insulating layer 53 which is part of insulating layer 50 and layers below the source line SL are omitted.

Fig. 4B is a cross-sectional view of the pillar PL along the Y direction at a height position of any selection gate line SGD. Fig. 4C is a cross-sectional view of the pillar PL along the Y direction at a height position of an any word line WL. Fig. 4D is a cross-sectional view of the pillar PL along the Y direction at a height position of any selection gate line SGS.

In the present specification, both the X direction and the Y direction are directions along the direction of the face of the word line WL, and the X direction and the Y direction are orthogonal to each other. In addition, the stacking direction of the word lines WL may be referred to as a first direction, and the first direction is a direction intersecting the X direction and the Y direction.

In addition, in the present specification, a side on which the drain-side selection gate line SGD is disposed is defined as an upper side of the semiconductor storage device 1, and a side on which the source-side selection gate line SGS is disposed is defined as a lower side of the semiconductor storage device 1. Such a vertical direction of the semiconductor storage device 1 also coincides with the penetrating direction of the pillar PL in the method of manufacturing the semiconductor storage device 1 described later. That is, it is assumed that the upper end of the pillar PL in the penetrating direction is the upper side of the semiconductor storage device 1 and the lower end of the pillar PL in the penetrating direction is the lower side of the semiconductor storage device 1.

As illustrated in Figs. 4A to 4D, a stacked body LM is disposed above the source line SL that is, for example, a conductive polysilicon layer or the like via, for example, an insulating layer 55. The stacked body LM has a configuration in which a plurality of word lines WL and a plurality of insulating layers OL are alternately stacked one by one. In addition, one or more selection gate lines SGD are disposed above the uppermost word line WL via the insulating layer OL. In addition, one or more selection gate lines SGS are disposed below the lowermost word line WL via the insulating layer OL.

That is, selection gate line SGS illustrated in Fig. 4D is disposed above the source line SL with insulating layer 55 interposed therebetween, for example, and insulating layers 51, 52, and 53 that cover the upper face of stacked body LM are disposed in this order above the selection gate line SGD illustrated in Fig. 4B. Note that these insulating layers 51 to 53 and 55 constitute part of the above-described insulating layer 50 (see Fig. 3) .

Here, the stacked number of word lines WL and the stacked number of selection gate lines SGD and SGS as the plurality of conductive layers in the stacked body LM are any number. As an example, the stacked number of the word lines WL and the stacked number of the selection gate lines SGD and SGS in the stacked body LM can be several tens to several hundreds. The word line WL and the selection gate lines SGD and SGS are, for example, a tungsten layer or a molybdenum layer. The insulating layers OL, 51 to 53, and 55 are, for example, silicon oxide layers or the like.

The stacked body LM is divided in the Y direction by a plurality of plate-shaped portions PT. Fig. 4A illustrates one of the plurality of plate-shaped portions PT.

The plate-shaped portions PT are disposed in the Y direction and extend in the stacking direction of the stacked body LM and the direction along the X direction. More specifically, the plate-shaped portion PT penetrates the insulating layers 52 and 51, the stacked body LM, and the insulating layer 55 to reach the source line SL, and continuously extends in the stacked body LM from one end to the other end of the stacked body LM in the X direction. Each of the plate-shaped portions PT is configured as a single body of an insulating layer 54 such as a silicon oxide layer.

In the memory region MR, a plurality of separation layers SHE penetrating the upper layer portion of the stacked body LM and extending in the direction along the X direction is disposed between the plate-shaped portions PT adjacent in the Y direction. The separation layer SHE is an insulating layer 56, such as a silicon oxide layer, that penetrates the selection gate line SGD and reaches the insulating layer OL immediately below.

In other words, the separation layers SHE penetrating the upper layer portion of the stacked body LM extend in the X direction in the memory region MR between the plate-shaped portions PT, so that the upper layer portion of the stacked body LM is partitioned into the selection gate lines SGD described above.

Note that a region between the plate-shaped portions PT adjacent in the Y direction is an example of a physical configuration corresponding to the above-described one block BLK (see Fig. 2). In addition, a region partitioned into the pattern of the selection gate line SGD by the separation layer SHE between the adjacent plate-shaped portions PT is an example of a physical configuration corresponding to the above-described string unit SU (see Fig. 2).

In the memory region MR of the stacked body LM, a plurality of pillars PL penetrating the insulating layer 51, the stacked body LM, and the insulating layer 55 to reach the source line SL is dispersedly disposed.

The plurality of pillars PL has, for example, a staggered arrangement when viewed in the stacking direction of the stacked body LM. Each pillar PL has, for example, a circular shape, an elliptical shape, an oval shape (oval shape), or the like as a cross-sectional shape in a direction along the layer direction of the stacked body LM, that is, in a direction along the XY plane.

Each of these pillars PL has a tapered shape in which the cross-sectional area and the diameter along the XY plane decrease from the upper end to the lower end, for example. Alternatively, each of these pillars PL has, for example, a bowing shape in which the cross-sectional area and the diameter along the XY plane are smaller at the lower end than at the upper end, and the cross-sectional area and the diameter along the XY plane are maximized between the upper end and the lower end. Such a shape of the pillar PL is obtained corresponding to the penetrating direction of the pillar PL in the method of manufacturing the semiconductor storage device 1 described later.

In other words, the penetrating direction of the pillars PL can be determined by the shapes of these pillars PL. That is, in general, a portion where the cross-sectional area and the diameter along the XY plane are large is the upper end of the pillar PL in the penetrating direction, and a portion where the cross-sectional area and the diameter are small is the lower end of the pillar PL in the penetrating direction.

Each of the plurality of pillars PL includes a core layer CR which extends in the stacked body LM in the stacking direction and serves as a core material of the pillar PL, a channel layer CN which covers a side face of the core layer CR and in which an upper cap layer CP and a lower cap layer EP are disposed at both ends in the vertical direction, and a memory layer ME which covers side faces of the upper cap layer CP, the channel layer CN, and the lower cap layer EP.

As illustrated in Figs. 4B to 4D, the memory layer ME is a multi-layered insulating layer in which a block insulating layer BK, a charge storage layer CT, and a tunnel insulating layer TN are stacked in this order from the outer peripheral side of the pillar PL. The channel layer CN extends in the stacked body LM in the stacking direction inside the memory layer ME. The further inside of the channel layer CN is filled with the core layer CR.

The lower cap layer EP is disposed at the lower end of the channel layer CN and is connected to the source line SL below the stacked body LM. In this manner, the channel layer CN and the source line SL are connected by the lower cap layer EP.

The upper cap layer CP is disposed at the upper end of the channel layer CN and is connected to the bit line BL disposed in the insulating layer 52 via the plug CH disposed in the insulating layers 53 and 53. In this manner, the channel layer CN and the bit line BL are connected by the upper cap layer CP. The bit line BL extends above the stacked body LM in, for example, a direction along the Y direction so as to intersect with the drawing direction of the word line WL.

In Fig. 4A, the plug CH is connected to only one pillar PL in the section separated by the separation layer SHE. The other pillars PL are connected to other bit lines BL extending in the direction along the Y direction in parallel with the bit line BL illustrated in Fig. 4A via a plug CH (not illustrated in Fig. 4A) at positions different from the cross section illustrated in Fig. 4A.

The block insulating layer BK and the tunnel insulating layer TN of the memory layer ME, and the core layer CR are, for example, silicon oxide layers or the like. The charge storage layer CT of the memory layer ME is, for example, a silicon nitride layer or the like. The channel layer CN, the upper cap layer CP, and the lower cap layer EP are semiconductor layers such as a silicon layer, and the lower cap layer EP further includes an N-type dopant (impurity) such as phosphorus.

More specifically, the channel layer CN is a crystalline semiconductor layer substantially entirely single crystallized. The channel layer CN may partially include polycrystals. The upper cap layer CP and the lower cap layer EP are amorphous silicon layers, polysilicon layers, or the like. Alternatively, the amorphous portion and the polycrystalline portion may be mixed at a predetermined ratio in the upper cap layer CP and the lower cap layer EP. Part of the upper cap layer CP and the lower cap layer EP may be single crystallized.

With the above configuration, the memory cells MC are formed in a portion where the side face of the pillar PL faces the respective word lines WL. When a predetermined voltage is applied from the word line WL, data is written to and read from the memory cell MC.

In addition, with the above configuration, a selection gate STD is formed in a portion where the side face of the pillar PL faces the selection gate line SGD disposed at the upper layer of the word line WL. In addition, a selection gate STS is formed in a portion where the side face of the pillar PL faces the selection gate line SGS disposed at the lower layer of the word line WL.

When predetermined voltages are applied from the selection gate lines SGD and SGS, the selection gates STD and STS are turned on or off, and the memory cell MC of the pillar PL to which the selection gates STD and STS belong can be brought into a selected state or a non-selected state.

Here, the channel layer CN includes a predetermined additive. The additive included in the channel layer CN is an electrically inactive element different from an impurity element that imparts a P-type or N-type conductivity type to the semiconductor layer, and has a property of inhibiting crystallization of the semiconductor layer such as the channel layer CN. As an example, the additive may be at least any one of carbon, nitrogen, oxygen, and fluorine.

The channel layer CN may include at least one metal element of nickel, palladium, and aluminum.

These additives and metal elements may be unevenly distributed in the channel layer CN. An example of such a case is illustrated in Figs. 4B to 4D.

The region CNb closer to the core layer CR illustrated in Figs. 4B to 4D is a region where the above-described additive has a peak concentration. In addition, the region CNa closer to a tunnel layer TN illustrated in Figs. 4B to 4D is a region that can include the above-described metal element.

More specifically, in the layer thickness direction of the channel layer CN, the concentration of the additive increases from the tunnel insulating layer TN toward the core layer CR. Therefore, these additives may be diffused not only in the region CNb but also in the entire channel layer CN. However, apart from nitrogen, oxygen, fluorine, and the like that are likely to diffuse in the channel layer CN, when the additive is carbon, the additive may have a peak concentration at least in the region CNb.

In addition, metal elements that can be included in the region CNa may also be diffused throughout the channel layer CN. However, it is considered that the metal element is easily detected at a portion in contact with the peak concentration position of the additive in the region CNa in the layer thickness direction of the channel layer CN.

As described above, the channel layer CN is substantially entirely single crystallized, and the presence of the regions CNa and CNb does not mean that the channel layer CN is divided into these regions CNa and CNb.

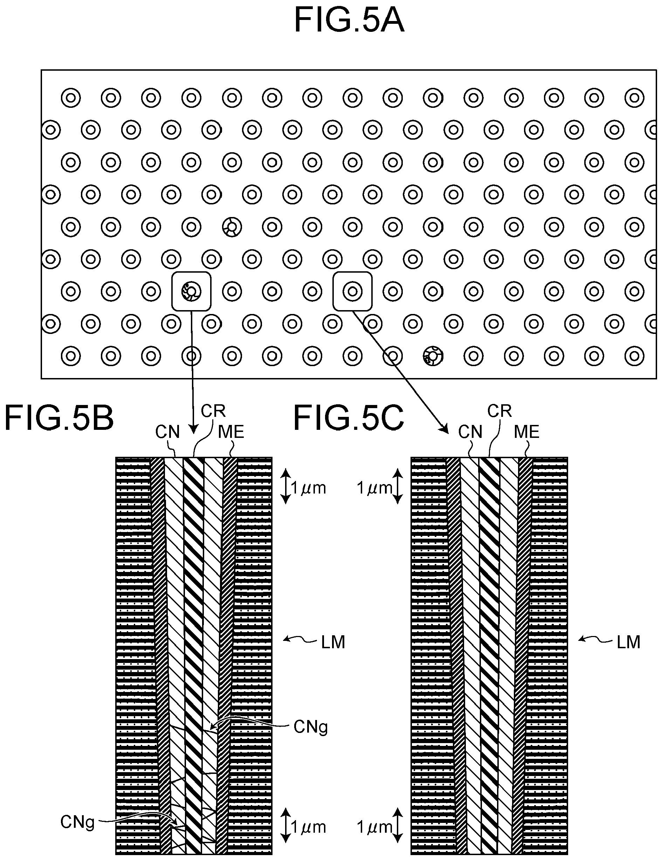

Figs. 5A to 5C are schematic diagrams illustrating a crystal structure of a channel layer CN included in a plurality of pillars PL of the semiconductor storage device 1 according to the embodiment.

More specifically, Fig. 5A is an XY cross-sectional view near to the lower end of the plurality of pillars PL, and schematically illustrates a crystal analysis result of the channel layer CN included in the pillar PL. Such crystal analysis can be performed using, for example, bright-field scanning transmission electron microscope (BF-STEM) or the like.

Fig. 5B is a cross-sectional view of the pillar PL having the channel layer CN including polycrystals along the extension direction. Fig. 5C is a cross-sectional view of the pillar PL having the channel layer CN not including polycrystals along the extension direction.

Each of the plurality of circular rings illustrated in Fig. 5A illustrates an XY cross section of the channel layer CN included in each pillar PL. That is, the outer edge of the toroidal ring is an outer wall portion, of the channel layer CN, in contact with the memory layer ME, and the inner edge of the toroidal ring is an inner wall portion, of the channel layer CN, in contact with the core layer CR.

As illustrated in Fig. 5A, each of the channel layers CN of many pillars PL is made of a single crystal. On the other hand, in some pillars PL, the circular ring indicating the channel layer CN is divided into a plurality of portions, which indicate that the channel layer CN is poly-crystallized at least in the cross section of Fig. 5A. As described above, there is the pillar PL as the first pillar having the channel layer CN partially poly-crystallized at a predetermined ratio among the plurality of pillars PL.

As illustrated in Fig. 5B, in such a pillar PL, the channel layer CN is more likely to be poly-crystallized from the upper end as the first end toward the lower end as the second end.

That is, in such a pillar PL, the average grain size of the crystals included in the channel layer CN decreases from the upper end to the lower end. The average grain size of the crystals of the channel layer CN at this time is, for example, 1 µm or more near to the upper end. The average grain size of the crystals of the channel layer CN at this time is, for example, 5 nm or more and 100 nm or less near to the lower end, and typically, for example, 20 nm or more and 30 nm or less.

Therefore, as described above, the ratio of the pillars PL in which part of the channel layer CN is poly-crystallized tends to increase from the upper end toward the lower end of the pillars PL.

Therefore, near to the lower end of the plurality of pillars PL illustrated in Fig. 5A, it can be seen that the channel layers CN of some of the pillars PL are poly-crystallized. As described above, the ratio of the pillars PL in which the grain boundaries appear in the channel layer CN due to the poly-crystallization of the channel layer CN in part of the vicinity of the lower end or the like is, for example, 4% or less of all the plurality of pillars PL. The lower limit value of the ratio of the pillars PL in which the grain boundaries appear in the channel layer CN is, for example, 0.1% or more, preferably 0.05% or more, and more preferably 0.01% or more.

On the other hand, near to the upper end of the plurality of pillars PL, the ratio of the pillars PL in which the grain boundary appears in the channel layer CN among all the plurality of pillars PL is, for example, less than 1%. In the vicinity of the center of the plurality of pillars PL in the extension direction, the ratio of the pillars PL in which the grain boundary appears in the channel layer CN among all the plurality of pillars PL is, for example, less than 2%.

Here, when the extension distance of the plurality of pillars PL is, for example, several µm or more and 10 µm or less, "near to" the upper end of the pillar PL means, for example, a height position below the upper end of the pillar PL by 0.5 µm. Further, "near to" the lower end of the pillars PL means, for example, a height position above the lower end of the pillar PL by 0.5 µm.

However, as will be described later, the distance from the lower end, of the pillar PL, at which the channel layer CN has the above-described crystal structure may be different depending on the processing further received by the channel layer CN after the formation of the channel layer CN.

In addition, as illustrated in Figs. 5B and 5C, the crystal structure of the channel layer CN included in the pillar PL can be defined from different viewpoints. That is, the crystal structure of the channel layer CN can be defined by the number of crystal grain boundaries (CNg in Fig. 5B) appearing in the channel layer CN within a predetermined distance in the extension direction of the plurality of pillars PL.

In this case, in the channel layer CN near to at least the upper end of the plurality of pillars PL, the appearance number of crystal grain boundaries per 1 µm in the extension direction of the pillars PL is, for example, less than 0.5. That is, when the crystal structure of the channel layer CN is observed at a distance of 1 µm along the extension direction of the pillars PL near to the upper end of the plurality of pillars PL, less than 0.5 crystal grain boundaries can be recognized in the channel layer CN.

On the other hand, in the case of the pillar PL having the channel layer CN partially poly-crystallized, in the channel layer CN near to the lower end of the pillar PL, the appearance number of crystal grain boundaries per 1 µm in the extension direction of the pillar PL may be, for example, 10 or more, and typically, 20 or more and 30 or less, for example.

### (Method of manufacturing semiconductor storage device)

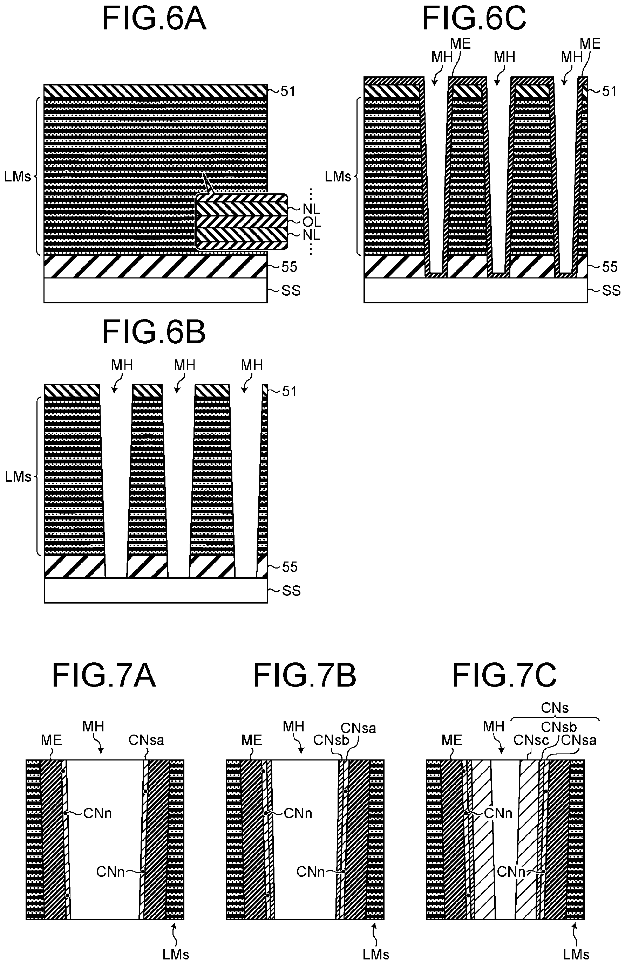

Next, a method of manufacturing the semiconductor storage device 1 according to the embodiment will be described with reference to Figs. 6A to 13F. Figs. 6A to 13F are diagrams sequentially illustrating part of the procedure of the method of manufacturing the semiconductor storage device 1 according to the embodiment.

First, a state in which a memory hole MH is formed in the stacked body LMs before the word line WL is formed is illustrated in Figs. 6A to 6C. Figs. 6A to 6C are cross-sectional views of a region to be the memory region MR later along the Y direction.

As illustrated in Fig. 6A, the insulating layer 55 such as a silicon oxide layer is formed on a support substrate SS. As the support substrate SS, a semiconductor substrate such as a silicon substrate, an insulating substrate such as a ceramic substrate, a conductive substrate such as an alumina substrate, or the like can be used.

On the insulating layer 55, a stacked body LMs in which a plurality of insulating layers NL as first insulating layers and a plurality of insulating layers OL as second insulating layers are stacked one by one is formed. The insulating layer NL is, for example, a silicon nitride layer or the like, and functions as a sacrificial layer that is later replaced with a conductive material and is the word line WL or the selection gate lines SGD and SGS.

In addition, an insulating layer 51 such as a silicon oxide layer covering the upper face of the stacked body LMs is formed.

As illustrated in Fig. 6B, the plurality of memory holes MH extending in the stacking direction of the stacked body LMs is formed. The memory hole MH is formed in a region to be the memory region MR later, and penetrates the insulating layer 51, the stacked body LMs, and the insulating layer 55 to reach the support substrate SS.

Here, the memory hole MH usually has a tapered shape in which the cross-sectional area and the diameter along the XY plane decrease in the penetrating direction in the stacked body LMs, that is, from the upper end to the lower end, or a bowing shape in which the cross-sectional area and the diameter along the XY plane are maximized between the upper and lower ends. Such a shape of the memory hole MH is also maintained in the pillar PL formed of the memory hole MH. As a result, the penetrating direction of the pillar PL may be determined in the finally obtained semiconductor storage device 1.

In Fig. 6B, a portion of the stacked body LMs on the left side of the drawing where the memory hole MH is not formed is a region where the plate-shaped portion PT is formed later.

As illustrated in Fig. 6C, the block insulating layer BK, the charge storage layer CT, and the tunnel insulating layer TN (see Figs. 4B to 4D) are stacked in this order in each of the plurality of memory holes MH to form the memory layer ME that covers each of the sidewalls and the bottom faces of the plurality of memory holes MH. The memory layer ME is also formed on the upper face of the insulating layer 51.

Next, Figs. 7A to 7C illustrate a state in which a channel layer CNs to be partially the channel layer CN (see Figs. 4A to 4D) is formed in the memory hole MH. Figs. 7A to 7C are enlarged cross-sectional views of the memory hole MH in which the memory layer ME is formed.

As illustrated in Figs. 7A to 7C, a source gas to be a semiconductor layer such as a silicon layer is supplied to form the channel layer CNs covering the memory layer ME formed in the memory hole MH. The channel layer CNs as the first semiconductor layer is an amorphous semiconductor layer such as an amorphous silicon layer, and is formed to be thicker than the above-described channel layer CN.

As illustrated in Fig. 7A, initially, the non-doped layer CNsa is formed so as to cover the memory layer ME by using a source gas not including an additive or the like. The non-doped layer CNsa is preferably formed to have a thickness of less than 5%, or at most less than 25% of the layer thickness that the amorphous channel layer CNs finally has.

At the interface with the memory layer ME, the structure of the non-doped layer CNsa, which is an amorphous silicon layer or the like, may be disturbed. Such a disturbance of the structure of the non-doped layer CNsa can occur, for example, in a portion whose density of silicon atoms is higher than that of the other portions, and can be a crystal nucleus CNn when the amorphous channel layer CNs is crystallized later.

As illustrated in Fig. 7B, after formation of the non-doped layer CNsa, supply of the source gas is continued while adding at least one of carbon, nitrogen, oxygen, and fluorine, whereby the doped layer CNsb to which the additive is added is formed so as to cover the non-doped layer CNsa. At this time, the peak concentration of the additive is, for example, 5×10¹⁹ or more and 1×10²¹ atoms/cm³ or less.

The doped layer CNsb is formed so that the layer thickness including the non-doped layer CNsa is less than 50%, more preferably 5% or more and less than 25% of the layer thickness that the amorphous channel layer CNs finally has.

As illustrated in Fig. 7C, the non-doped layer CNsc is formed so as to cover the doped layer CNsb by continuing the supply of the source gas for a predetermined period even after the addition of the additive is stopped. When the layer is thicker than the channel layer CN, the formation of the channel layer CNs is completed.

Note that the above numerical values regarding the layer thicknesses of the non-doped layer CNsa, the doped layer CNsb, and the non-doped layer CNsc are merely approximate numerical values without considering the volume change accompanying the conversion of the crystal structure from amorphous to crystalline. In addition, at least part of the additive added at the time of forming the doped layer CNsb can be diffused into the non-doped layers CNsa and CNsc through the subsequent treatment. Even in this case, the additive preferably has a peak concentration in the doped layer CNsb.

As described above, the amorphous channel layer CNs covering the sidewall and the bottom face of the memory hole MH is formed via the memory layer ME. The channel layer CNs is also formed on the upper face of the insulating layer 51 via the memory layer ME.

However, in the above description, for convenience of description, it is assumed that the channel layer CNs includes the non-doped layer CNsa, the doped layer CNsb, and the non-doped layer CNsc, but the channel layer CNs is formed by adding an additive for a predetermined period at a predetermined timing while continuing the supply of the source gas. Therefore, the non-doped layer CNsa, the doped layer CNsb, and the non-doped layer CNsc may be seamlessly formed in the channel layer CNs.

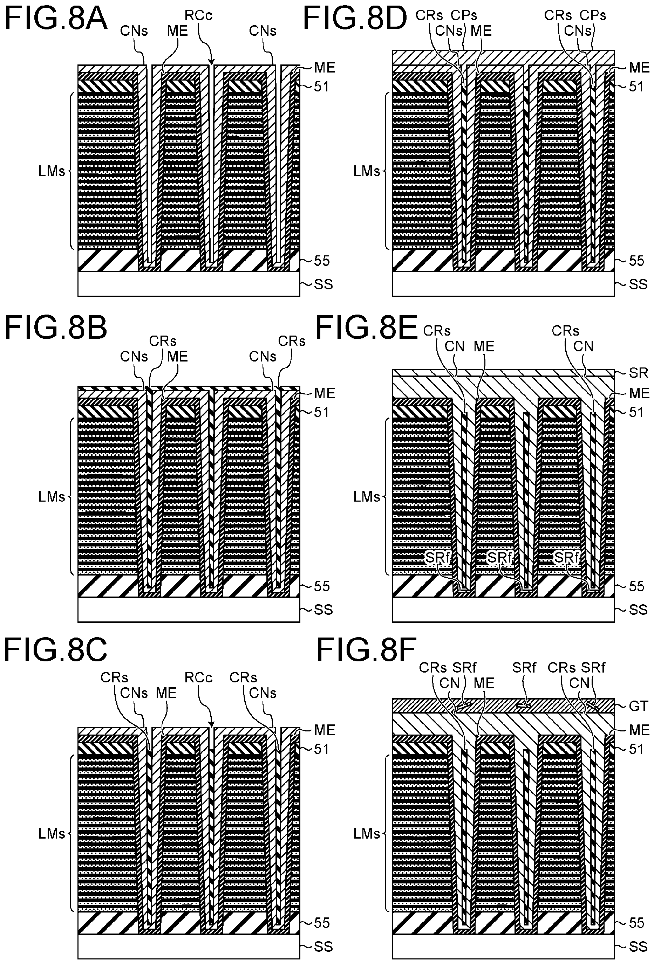

Next, Figs. 8A to 8F illustrate how the amorphous channel layer CNs is crystallized to form the channel layer CN. Figs. 8A to 8F are cross-sectional views of a region to be the memory region MR later along the Y direction, as in Figs. 6A to 6C described above.

Fig. 8A illustrates a state in which the channel layer CNs is formed on the sidewall and the bottom face of the memory hole MH and the upper face of the insulating layer 51 via the memory layer ME.

As illustrated in Fig. 8B, the inside of the channel layer CNs of the memory hole MH is filled with the core layer CRs. The core layer CRs is, for example, a silicon oxide layer or the like, and functions as a sacrificial layer to be removed in a later process. The core layer CRs is also formed on the upper face of the insulating layer 51 via the channel layer CNs and the memory layer ME.

As illustrated in Fig. 8C, the core layer CRs is etched back and removed from the upper face of the insulating layer 51 and the upper end of the memory hole MH. As a result, the channel layer CNs is exposed on the upper face of the insulating layer 51. In addition, the upper end of the core layer CRs is located at a predetermined depth in the memory hole MH, and a recess RCc is formed above the core layer CRs.

The recess RCc in the memory hole MH is obtained, for example, by continuing overetching for a predetermined time even after the core layer CRs on the upper face of the insulating layer 51 is removed.

As illustrated in Fig. 8D, a cap layer CPs covering channel layer CNs on the upper face of insulating layer 51 is formed. The cap layer CPs is, for example, a sacrificial layer such as an amorphous silicon layer, and is removed in a later process. The recess RCc in the memory hole MH is filled with the cap layer CPs.

As illustrated in Fig. 8E, a metal layer SR covering the cap layer CPs on the channel layer CNs is formed. The metal layer SR is, for example, a silicide layer or the like in which one or more metals of nickel, palladium, and aluminum are silicided by a surface layer portion of the cap layer CPs which is an amorphous silicon layer or the like. Such a metal layer SR is formed, for example, by sputtering one or more metals of nickel, palladium, and aluminum.

In addition, the channel layer CNs and the cap layer CPs are crystallized by an annealing treatment using metal assist or the like to form the substantially single crystallized channel layer CN.

That is, in a state where the metal layer SR is formed on the cap layer CPs, the annealing treatment is performed at a temperature of 500°C or more and 600°C or less, which is usually a temperature at which the amorphous silicon layer is not crystallized, for example, at 550°C. As a result, the metal layer SR on the cap layer CPs serves as a catalyst, and substantially the entire cap layer CPs and channel layer CNs are single crystallized. At this time, part of the metal layers SR serving as a catalyst for single crystallization is segregated near to the lower end of the channel layer CN as metal fragments SRf each of which is shredded.

As illustrated in Fig. 8F, a gettering layer GT such as an amorphous silicon layer is formed on the upper face of the channel layer CN, and an annealing treatment is performed at a temperature of 500°C or higher. As a result, a metal fragment SRf segregated in the channel layer CN moves into the gettering layer GT. Therefore, most of the metal fragments SRf in the channel layer CN can be removed.

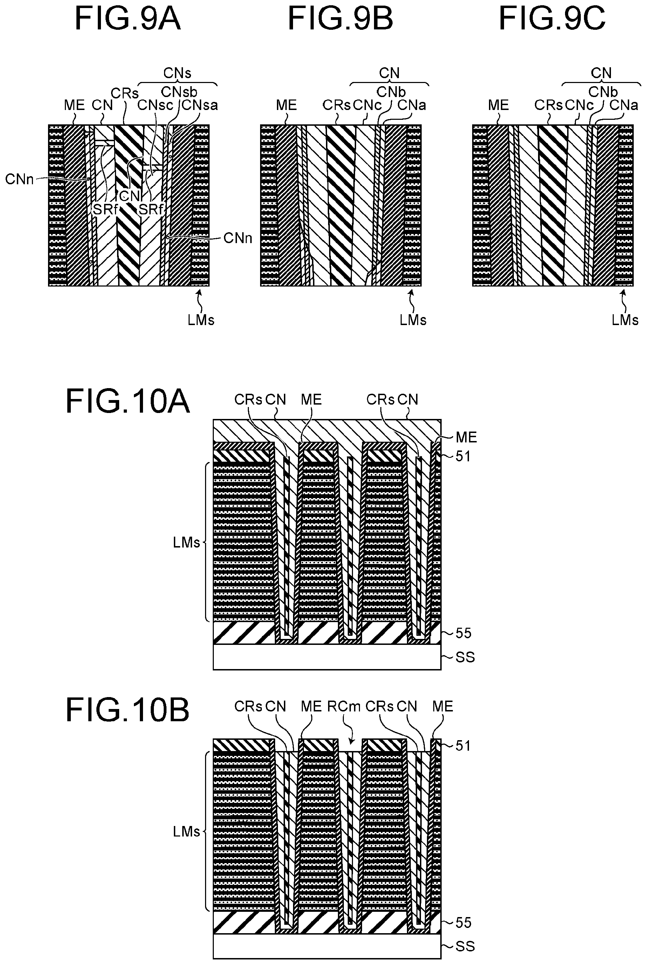

Here, Figs. 9A to 9C illustrate a more detailed aspect of the above treatment for converting the amorphous channel layer CNs into the crystalline channel layer CN. Figs. 9A to 9C are enlarged cross-sectional views of the memory hole MH in which the memory layer ME is formed, as in Figs. 7A to 7C described above.

As illustrated in Fig. 9A, crystallization proceeds from the upper face of cap layer CPs toward the lower end of channel layer CNs using the metal layer SR on cap layer CPs as a catalyst. In this way, when the cap layer CPs and the channel layer CNs are crystallized and a region of the channel layer CN which is substantially single crystallized appears, at least part of the metal layer SR on the upper face of the cap layer CPs is a metal fragment SRf which is shredded, and moves downward in the cap layer CPs and the channel layer CNs by migration.

On the other hand, a crystal nucleus CNn in the non-doped layer CNsa generated at the interface with the memory layer ME is formed into microcrystals in spite of the annealing treatment at a temperature at which the amorphous silicon layer is not crystallized without metal assist, and the crystallization of the channel layer CNs by metal assist may be inhibited.

However, channel layer CNs includes a doped layer CNsb formed in contact with the non-doped layer CNsa. The additive in the doped layer CNsb has a property of inhibiting crystallization of the channel layer CNs as described above. Therefore, the doped layer CNsb locally has crystal defects, and the crystal nucleus CNn in the non-doped layer CNsa are easily trapped in the doped layer CNsb. As a result, the crystal nucleus CNn disappear without becoming microcrystals and inhibition of the channel layer CNs into crystallization is suppressed.

As described above, the additive in the doped layer CNsb has a function of gettering the crystal nucleus CNn in the non-doped layer CNsa. The additive in the doped layer CNsb also decreases the rate of metal-assisted crystallization of the channel layer CNs.

As illustrated in Fig. 9B, along with the movement of the metal fragment SRf, crystallization also proceeds in the depth direction of the channel layer CNs. As a result, substantially the whole of the cap layer CPs and the channel layer CNs is single crystallized, and the channel layer CN as the second semiconductor layer including the regions CNa, CNb, and CNc is formed. Thereafter, the metal fragment SRf included in the channel layer CN by the migration is removed by the process of Fig. 8F described above.

A region CNa of the channel layer CN is a portion where the non-doped layer CNsa is crystallized, a region CNb is a portion where the doped layer CNsb is crystallized, and a region CNc is a portion where the non-doped layer CNsc is crystallized.

Here, the additive in the doped layer CNsb has a function of gettering the metal element in the metal fragment SRf. Therefore, the metal element impregnated in the channel layer CNs by migration can be segregated in the non-doped layer CNsa including the face, of the doped layer CNsb, in contact with the non-doped layer CNsa. As a result, even after the metal fragment SRf is removed, the metal element may remain in the region CNa of the channel layer CN.

Further, as described above, since the doped layer CNsb decreases the crystal acceleration of the channel layer CNs, the amorphous channel layer CNs may remain partially in the lower part of the channel layer CN even after the annealing treatment using metal assist. Therefore, after the removal of the metal fragment SRf, the annealing treatment is further performed at a temperature higher than 800°C, for example. As a result, the remaining amorphous portion undergoes solid phase growth and is incorporated into the portion of the channel layer CN that is already single crystallized.

Fig. 9C illustrates a state in which substantially the entire channel layer CN is single crystallized by the solid phase growth in the further annealing treatment.

As described above, the process of disposing the metal layer SR serving as a catalyst at the upper ends of the cap layer CPs and the channel layer CNs to be crystallized and causing the metal-assisted crystallization to proceed from the upper side to the lower side is also referred to as a metal induced lateral crystallization (MILC) annealing treatment.

By the MILC annealing treatment as described above, the channel layer CN having the crystal structure as described above is obtained. That is, among the plurality of memory holes MH, the ratio of the memory holes MH in which the crystal grain boundary appears in the cross section along the XY plane of the channel layer CN is, for example, less than 1% near to the upper end of the memory hole MH, that is, at a height position below the upper end of the memory hole MH, for example, by 0.5 µm, is, for example, less than 2% at the central portion of the memory hole MH in the extension direction, and, is for example, 4% or less near to the lower end of the memory hole MH, that is, at a height position above the lower end of the memory hole MH, for example, by 0.5 µm. The lower limit value of the ratio of the memory hole MH near to the lower end is, for example, 0.1% or more, preferably 0.05% or more, and more preferably 0.01% or more.

Next, a state in which the channel layer CN is further processed to form the pillar PL is illustrated in Figs. 10A to 11F. Figs. 10A to 11F are cross-sectional views of a region to be the memory region MR later along the Y direction, as in Figs. 8A to 8F and the like described above.

Fig. 10A illustrates a cross section of the entire pillar PL in which the crystalline channel layer CN is formed.

As illustrated in Fig. 10B, the channel layer CN and the memory layer ME are etched back and removed from the upper face of the insulating layer 51. As a result, the upper face of the insulating layer 51 is exposed. At this time, the channel layer CN and the core layer CRs are etched back also in the memory hole MH. As a result, the upper ends of the channel layer CN and the core layer CRs are located at a predetermined depth in the memory hole MH, and a recess RCm is formed above the channel layer CN and the core layer CRs.

The recess RCm in the memory hole MH is obtained, for example, by continuing overetching for a predetermined time even after the channel layer CN on the upper face of the insulating layer 51 is removed. At this time, the upper ends of the channel layer CN and the core layer CRs are maintained at a height position above at least the uppermost insulating layer NL of the stacked body LMs by controlling an overetching time or the like. By leaving the channel layer CN at the height position of the uppermost insulating layer NL to be the selection gate line SGD later, this portion of the pillar PL can function as the selection gate STD.

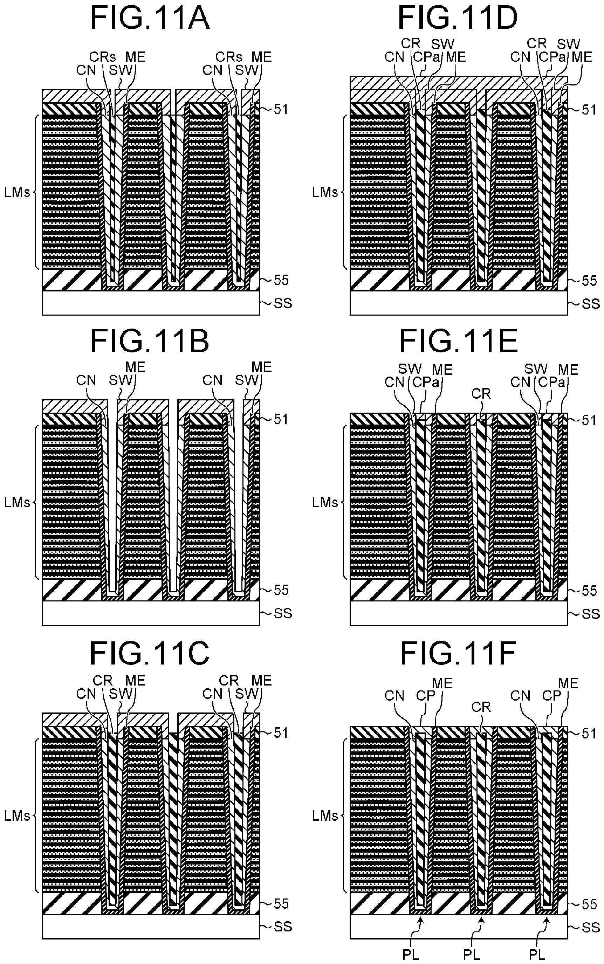

As illustrated in Fig. 11A, a sidewall layer SW that covers the upper face of the insulating layer 51 is formed. The sidewall layer SW is also formed in the recess RCm at the upper end of the memory hole MH so as to cover the sidewall of the memory hole MH, and protects the memory layer ME in the slimming process of the channel layer CN described later. The sidewall layer SW is, for example, an amorphous silicon layer or the like. By controlling the treatment time and the like, the layer thickness of the sidewall layer SW is adjusted so that the recess RCm is not completely closed.

As illustrated in Fig. 11B, the core layer CRs in the memory hole MH is removed and the channel layer CN is thinned by wet etching, isotropic dry etching, or the like. At this time, the memory layer ME on the sidewall of the memory hole MH is protected by the sidewall layer SW.

By the slimming treatment for thinning the channel layer CN, the region CNc among the regions CNa, CNb, and CNc included in the channel layer CN is substantially completely removed. Part of the region CNb can also be removed. At this time, in the layer thickness direction of the channel layer CN, for example, the region CNb may be removed until a portion where the additive in the region CNb has a peak concentration is exposed as a new surface of the channel layer CN. As a result, the above-described channel layer CN having the regions CNa and CNb but not having the region CNc is formed.

As described above, by initially forming the thick channel layer CNs and performing the annealing treatment or the like, the crystallization of the channel layer CNs is easily promoted. Further, by slimming the crystallized channel layer CN, the depletion layer can be made thinner than the length of the channel layer CN corresponding to the gate length in the stacking direction, and the short channel effect can be suppressed.

As illustrated in Fig. 11C, the core layer CRs is removed, and the void in the memory hole MH generated by slimming the channel layer CN is filled with a silicon oxide layer or the like to form the core layer CR. At this time, the height position of the upper end of the core layer CR is adjusted so as to be equal to or higher than the height position of the upper end of the channel layer CN. By maintaining the shape of the channel layer CN at the height position of the uppermost insulating layer NL to be the selection gate line SGD later in an annular shape, this portion of the pillars PL can function as the selection gate STD.

As illustrated in Fig. 11D, a cap layer CPa covering the sidewall layer SW on the upper face of the insulating layer 51 is formed. The cap layer CPa is an amorphous silicon layer or the like that is crystallized later to become the upper cap layer CP. The recess RCm at the upper end of the memory hole MH is also filled with the cap layer CPa.

As illustrated in Fig. 11E, the cap layer CPa and the sidewall layer SW are etched back and removed from the upper face of the insulating layer 51. At this time, control is performed so that the overetching amount is suppressed, and the cap layer CPa and the sidewall layer SW in the memory hole MH are not removed.

As illustrated in Fig. 11F, the remaining cap layer CPa and sidewall layer SW are crystallized by, for example, annealing treatment or the like to form the upper cap layer CP. The degree of crystallization in the upper cap layer CP may not be as high as that in the channel layer CN described above, and the upper cap layer CP may be, for example, a polysilicon layer or the like. An amorphous silicon layer may remain in part of the upper cap layer CP, or part thereof may be single crystallized.

Thus, the pillar PL is formed. However, at this point, the lower cap layer EP is not formed at the lower end of the channel layer CN of the pillar PL.

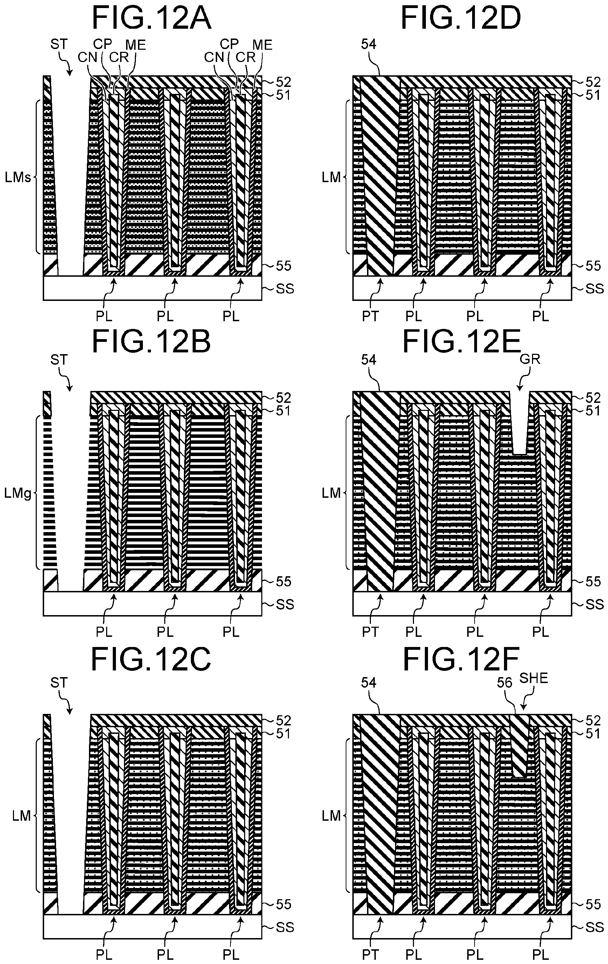

Next, Figs. 12A to 12F illustrate how the stacked body LM is formed by replacing the plurality of insulating layers NL with the word lines WL and the like. Figs. 12A to 12F are cross-sectional views of a region to be the memory region MR later along the Y direction, as in Figs. 10A to 11F and the like described above.

As illustrated in Fig. 12A, an insulating layer 52 is formed on insulating layer 51. In addition, a slit ST that penetrates the insulating layers 52 and 51, the stacked body LMs, and the insulating layer 55 and reaches the support substrate SS is formed. The slit ST also extends in the direction along the X direction in the stacked body LMs.

As illustrated in Fig. 12B, a removing liquid such as thermal phosphoric acid is injected from the upper portion of the slit ST to remove an insulating layer NL in the stacked body LMs exposed to the side face of the slit ST. As a result, the stacked body LMg having a void between the plurality of insulating layers OL is formed.

As illustrated in Fig. 12C, a source gas serving as a source such as an electric conductor is injected from the upper portion of the slit ST, and the void is filled with a conductive layer to form the word line WL and the selection gate lines SGD and SGS. As a result, a stacked body LM in which the plurality of word lines WL and the selection gate lines SGD and SGS are stacked is formed. At this point, however, the selection gate line SGD is not separated into the plurality of sections.

Note that the process of removing the insulating layer NL to form the word line WL and the like is also referred to as a replacement process.

As illustrated in Fig. 12D, the slit ST is filled with the insulating layer 54 to form the plate-shaped portion PT.

As illustrated in Fig. 12E, in order to form a separation layer SHE, a groove GR that penetrates the insulating layers 52 and 51 and the selection gate line SGD and extends in the direction along the X direction is formed. In other words, among the conductive layers in the stacked body LM, the groove GR penetrates the conductive layer desired to function as the selection gate line SGD to be separated into the plurality of patterns of the selection gate lines SGD.

As illustrated in Fig. 12F, the groove GR is filled with the insulating layer 56 to form the separation layer SHE.

Thereafter, the insulating layer 53 is formed on the insulating layer 52, and a plug CH penetrating the insulating layers 53 and 52 and connected to the upper cap layer CP of the pillar PL and the bit line BL connected to the plug CH are formed through.

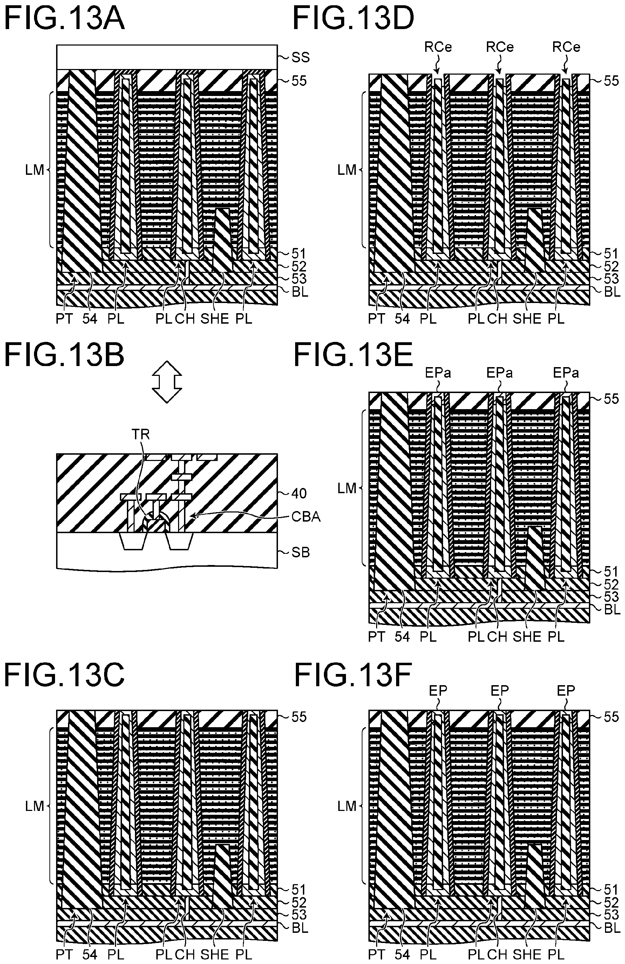

Next, a state in which the lower cap layer EP is formed at the lower end of the pillar PL is illustrated in Figs. 13A to 13F. Figs. 13A to 13F are cross-sectional views of a region to be the memory region MR later along the Y direction, as in Figs. 12A to 12F and the like described above.

As illustrated in Figs. 13A and 13B, the face of the support substrate SS in which the pillar PL is formed in the stacked body LM and the plugs CH and the bit lines BL are formed in the insulating layers 52 and 53 covering the stacked body LM is made to face a face of the semiconductor substrate SB separated from the support substrate SS, the peripheral circuit CBA being formed in the face. Note that the peripheral circuit CBA is covered with the insulating layer 40, and a contact, a via, a wiring, and the like electrically connected to the peripheral circuit CBA are formed in the insulating layer 40.

Thereafter, the insulating layer 50 including the insulating layers 51 to 53 on the support substrate SS side and the insulating layer 40 on the semiconductor substrate SB side are joined. These insulating layers 50 and 40 can be joined by being activated in advance by, for example, plasma treatment or the like. When the insulating layers 50 and 40 are joined, the support substrate SS and the semiconductor substrate SB are aligned so that an electrode pad (not illustrated) formed on the surface of the insulating layer 50 and electrically connected to the pillars PL and the like and an electrode pad formed on the surface of the insulating layer 40 and electrically connected to the peripheral circuit CBA overlap.

After the insulating layers 50 and 40 are joined, an annealing treatment is performed to join both electrode pads by, for example, Cu-Cu joining. As a result, the support substrate SS and the semiconductor substrate SB are joined together.

Hereinafter, the illustration of the configuration on the semiconductor substrate SB side joined to the insulating layer 50 is omitted.

As illustrated in Fig. 13C, the entire support substrate SS and part of the insulating layer 55 above the stacked body LM are removed by chemical mechanical polishing (CMP) or the like. As a result, the upper ends of the pillars PL and the plate-shaped portion PT are exposed on the ground upper face of the insulating layer 55. In addition, the entire memory layer ME covering the upper face of the pillar PL and part of the upper end of the channel layer CN are removed, and the channel layer CN is exposed from the upper end of the pillar PL.

As illustrated in Fig. 13D, recess etching is performed on the exposed channel layer CN while taking a selection ratio of the sidewall of the pillar PL to the memory layer ME, and the upper end of the channel layer CN is retracted in the depth direction of the pillar PL. As a result, a recess RCe is formed at the upper end of the pillar PL.

Note that, by taking a selection ratio with the memory layer ME during the recess etching, etching deletion of the insulating layer 55 including the same type of material as the memory layer ME is also suppressed. In addition, by taking a selection ratio with the memory layer ME, the core layer CR including the same type of material as the memory layer ME may protrude into the recess RCe.

As illustrated in Fig. 13E, the recess RCe at the upper end of the pillar PL is filled with a cap layer EPa such as an amorphous silicon layer or a polysilicon layer. In addition, the cap layer EPa is doped with a dopant such as phosphorus by ion implantation or the like.

As illustrated in Fig. 13F, for example, the dopant in the cap layer EPa is activated by activation annealing performed by irradiation with laser light. As a result, the lower cap layer EP in which the dopant in the cap layer EPa is activated is formed.

As described above, the pillar PL having the lower cap layer EP at the lower end is formed.

Note that the lower end of the pillar PL including the memory layer ME and the channel layer CN is partially removed by the above-described process of forming the lower cap layer EP at the lower end of the pillar PL. In the cross section along the XY plane of the channel layer CN, the distance from the lower end of the pillar PL to a portion where the ratio of the pillars PL in which the crystal grain boundaries appear is, for example, 4% or less may slightly vary depending on the amount of removal at this time. That is, in the above description, "near to" the lower end of the pillar PL means a position above the lower end of the pillar PL by 0.5 µm, but this distance is merely an example.

Thereafter, the source line SL such as a polysilicon layer covering the insulating layer 55 in which the lower end of the pillar PL on which the lower cap layer EP is formed and the lower end of the plate-shaped portion PT are exposed is formed. Further, the electrode layer EL is formed above the source line SL via the insulating layer 60 in which the plug PG is formed.

As described above, the semiconductor storage device 1 of the embodiment is manufactured.

### (Overview)

In a semiconductor storage device such as a three-dimensional nonvolatile memory, for example, a pillar including a channel layer and a memory layer has a function of a memory cell. By appropriately controlling the crystal structure of the channel layer by single crystallizing the channel layer, which is a semiconductor layer or the like, the electrical resistance of the channel layer can be reduced, and noise derived from the channel layer CN can be reduced to obtain a memory cell having good electrical characteristics.

Here, for example, when an amorphous channel layer is formed and crystallized by a simple annealing treatment or the like, the channel layer has a substantially 100% polycrystalline crystal structure. In this case, the appearance number of crystal grain boundaries in the channel layer over the entire pillar is, for example, 1 or more per 50 nm in the extension direction of the pillar.

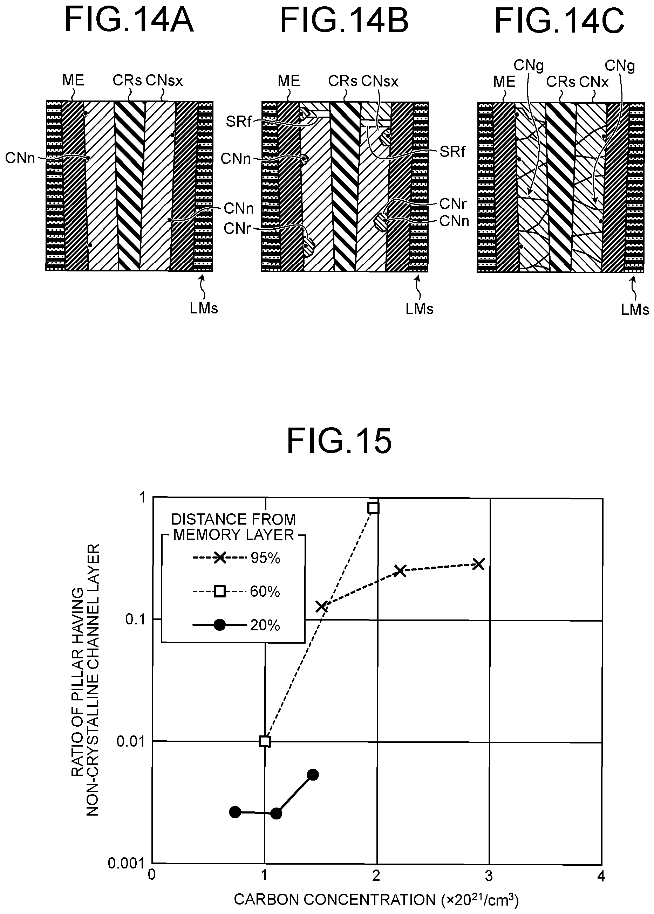

Therefore, in order to single crystallize the channel layer, for example, an annealing treatment using metal assist such as MILC annealing treatment is used. However, single crystallization of the channel layer by metal assist may be inhibited due to, for example, formation of the crystal nucleus in the amorphous channel layer before crystallization. This state is illustrated in Figs. 14A to 14C.

Figs. 14A to 14C are enlarged cross-sectional views of a memory hole illustrating a state in which an amorphous channel layer CNsx according to a comparative example is converted into a crystalline channel layer CNx.

As illustrated in Fig. 14A, in the manufacturing process of the semiconductor storage device of the comparative example, a channel layer CNsx that is an amorphous semiconductor layer such as an amorphous silicon layer and is a non-doped layer as a whole is formed. In the vicinity of the interface with the memory layer ME of the channel layer CNsx, the crystal nucleus CNn due to disturbance of the structure of the channel layer CNsx or the like is formed.

As illustrated in Fig. 14B, the annealing treatment is performed at a temperature of 500°C or higher and 600°C or lower in a state where a metal layer which is a silicide layer of nickel, palladium, aluminum or the like is formed on the upper side of the channel layer CNsx. As a result, metal-assisted crystallization is started from the upper end of the channel layer CNsx.

On the other hand, at this time, the crystal nucleus CNn in the channel layer CNsx grow into microcrystals, and the metal-assisted homogeneous crystallization of the channel layer CNsx is inhibited.

As illustrated in Fig. 14C, the crystal nucleus CNn are inhibited by the grown microcrystals, and a poly-crystallized channel layer CNx is formed. As a result, a large number of crystal grain boundaries CNg are generated in the channel layer CNx.

As described above, even in the case of using the annealing treatment using the metal assist, among the plurality of pillars, the pillar in which the crystal grain boundary appears in the cross section along the XY plane of the channel layer is generated by about 1% even near to the upper end of the pillar.

According to the method of manufacturing the semiconductor storage device 1 of the embodiment, an additive that is one or more of carbon, nitrogen, oxygen, and fluorine is added to the channel layer CNs closer to the memory layer ME in the layer thickness direction. As a result, it is possible to trap the crystal nucleus CNn formed in the vicinity of the interface with the memory layer ME of the channel layer CNs and to suppress the inhibition of the single crystallization of the channel layer CNs by the MILC annealing treatment.

According to the method of manufacturing the semiconductor storage device 1 of the embodiment, the additive is added so that the distance from the memory layer ME has a peak concentration in a region of less than 50%, more preferably 5% or more and less than 25% of the entire layer thickness of the channel layer CNs. As a result, the trapping effect of the crystal nucleus CNn by the doped layer CNsb to which the additive is added can be enhanced.

Fig. 15 is a graph illustrating an appropriate position of the doped layer CNsb introduced into the channel layer CNs according to the embodiment.

The horizontal axis of the graph illustrated in Fig. 15 is the concentration of carbon used as an additive, and the vertical axis of the graph is the ratio of pillars in which the channel layer is completely amorphous in the XY cross section near to the lower end of the plurality of pillars.

In addition, the graph of Fig. 15 illustrates data in a case where carbon is added at positions where the distance from the memory layer is 95%, 60%, and 20% of the layer thickness of the entire channel layer before slimming.

In the example illustrated in Fig. 15, the ratio of pillars in which the channel layer is amorphous was the highest in a case where carbon was added at a position where the distance from the memory layer was 60% of the layer thickness of the entire channel layer. In addition, it has been found that the ratio of pillars in which the channel layer is amorphous is the lowest in a case where carbon was added at a position at which the distance from the memory layer is 20% of the layer thickness of the entire channel layer.

As described above, it is found that the trap effect of the crystal nucleus is enhanced when the position to which carbon is added is in the vicinity of the memory layer. On the other hand, for example, when the carbon added region is formed so as to be in contact with the memory layer, electrons flowing through the channel layer during the electrical operation of the memory cell may be scattered or captured by the carbon added region. As a result, there is a possibility that the electrical characteristics of the memory cell are deteriorated.

In the embodiment, since the region CNb of the channel layer CN is not brought into contact with the memory layer ME, such scattering and capturing of electrons can be suppressed to maintain the electrical characteristics of the memory cell.

According to the semiconductor storage device 1 of the embodiment, near to at least the upper end of the pillar PL, the channel layer CN has a crystal structure in which the appearance number of crystal grain boundaries per 1 µm in the extension direction of the pillar PL is less than 0.5.

According to the semiconductor storage device 1 of the embodiment, the ratio of the pillars PL in which the crystal grain boundary appears in the channel layer CN among the plurality of pillars PL is less than 2% in a cross section along the XY plane, the cross section being at the center of the plurality of pillars PL in the extension direction.

Among the plurality of pillars PL, the ratio of the pillars PL in which the crystal grain boundaries appear in the channel layer CN is less than 1% in the cross section near to the upper end of the pillars PL and 4% or less in the cross section near to the lower end of the pillars PL. The lower limit of the ratio near to the lower end of the pillar is 0.1% or more, preferably 0.05% or more, and more preferably 0.01% or more.

As described above, the degree of single crystallization of the channel layer CN in a case where the additive is added to part of the channel layer CNs and the metal-assisted annealing treatment is performed can be increased as compared with that in a case where the annealing treatment is performed without adding the additive to the amorphous channel layer. As a result, the resistance of the channel layer CN can be reduced, and noise derived from the channel layer CN can be reduced to improve the electrical characteristics of the memory cell MC.

### (Modification)

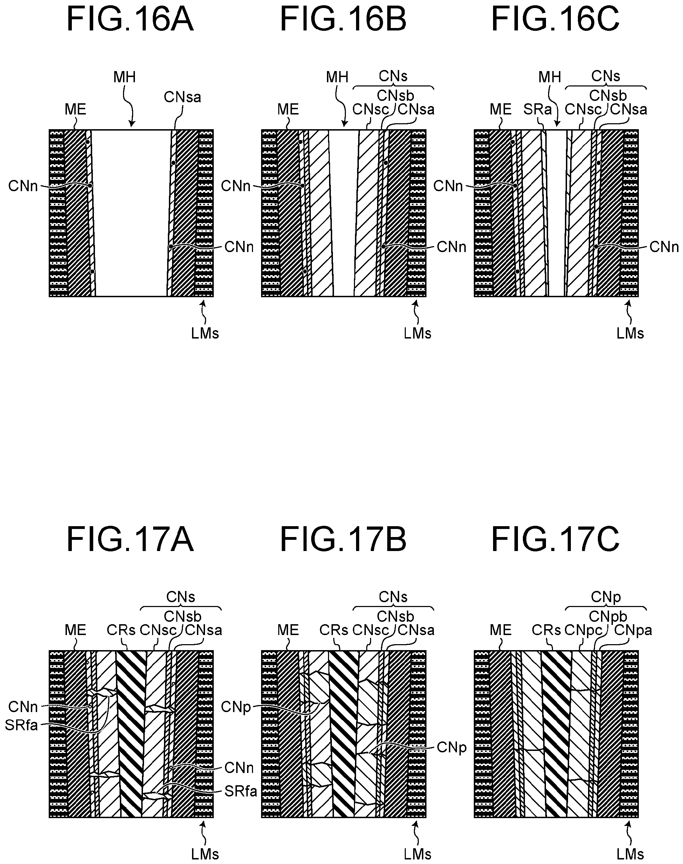

Next, a method of manufacturing a semiconductor storage device according to a modification of the embodiment will be described with reference to Figs. 16A to 17C. The method of manufacturing the semiconductor storage device according to the modification is different from that of the above-described embodiment in a method of annealing treatment using metal assist.

In the following drawings, the same reference numerals are given to the same configurations as those of the above-described embodiment, and the description thereof may be omitted.

Figs. 16A to 17C are enlarged cross-sectional views sequentially illustrating part of the procedure of the method of manufacturing the semiconductor storage device according to the modification of the embodiment.

As illustrated in Figs. 16A and 16B, also in the method of manufacturing the semiconductor storage device of the modification, the amorphous channel layer CNs is formed in the same manner as in the above-described embodiment. That is, the channel layer CNs includes the non-doped layer CNsa that can include the crystal nucleus CNn, the doped layer CNsb including an additive of at least one of carbon, nitrogen, oxygen, and fluorine, and the non-doped layer CNsc in this order from the memory layer ME side.

As illustrated in Fig. 16C, a metal layer SRa covering the inner wall face of channel layer CNs is formed. The metal layer SRa is, for example, a silicide layer or the like in which one or more metals of nickel, palladium, and aluminum are silicided by a surface layer portion of the channel layer CNs which is an amorphous silicon layer or the like.

Thereafter, the void remaining in the memory hole MH is filled with the core layer CRs.

As illustrated in Fig. 17A, the annealing treatment is started at a temperature of 500°C or higher and 600°C or lower, for example, 550°C. As a result, the metal layer SRa on the inner wall face of the channel layer CNs is the fragmented metal fragment SRfa and impregnates into different height positions in the channel layer CNs.

On the other hand, the crystal nucleus CNn included in the non-doped layer CNsa of the channel layer CNs is trapped in the doped layer CNsb of the channel layer CNs and disappears.

As illustrated in Fig. 17B, by continuing the annealing treatment, the crystallization of the channel layer CNs is started at different height positions in the channel layer CNs using the metal fragment SRfa as a catalyst, and a crystalline channel layer CNp is formed and grown in various places.

As illustrated in Fig. 17C, the channel layer CNp substantially entirely single crystallized is formed by the annealing treatment using the metal assist and the subsequent additional annealing treatment at 800°C or higher. The channel layer CNp includes regions CNna, CNnb, and CNnc in which the non-doped layer CNsa, the doped layer CNsb, and the non-doped layer CNsc of the channel layer CNs are crystallized, respectively. As in the above-described embodiment, a region CNna of the channel layer CNp may include the metal element used for metal assist. The peak concentration of the additive is located, for example, in a region CNnb.

In this manner, a process of providing the metal layer SRa serving as a catalyst on the side face of the channel layer CNs and promoting metal-assisted crystallization at different height positions in the channel layer CNs is also referred to as a metal induced crystallization (MIC) annealing treatment. In the MIC annealing treatment, since crystallization proceeds in various places of the channel layer CNs, a crystal grain boundary CNg appearing in the finally obtained channel layer CNp may be slightly increased as compared with the case of crystallization by the MILC annealing treatment described above.

Even in this case, the difference in quality between the channel layer CNp formed by the MIC annealing treatment and the channel layer CN of the above-described embodiment formed by the MILC annealing treatment is very small. For example, in the case of the channel layer CNp by the MIC annealing treatment, in the channel layer CNp near to at least the upper end of the plurality of pillars, the appearance number of crystal grain boundaries per 1 µm in the extension direction of the pillars is, for example, less than two.

The characteristics of the channel layer CNp on the crystal structure other than the above are substantially equal to those of the channel layer CN of the above-described embodiment. That is, among the plurality of pillars, the ratio of the pillars in which the crystal grain boundaries appear in the cross section along the XY plane of the channel layer CNp is, for example, less than 1% near to the upper end of the pillars, that is, at a height position below the upper end of the pillars, for example, by 0.5 µm, is, for example, less than 2% at the central portion of the pillars in the extension direction, and is, for example, 4% or less near to the lower end of the pillars, that is, at a height position above the lower end of the pillars, for example, by 0.5 µm. The lower limit value of the ratio near to the lower end of the pillar is, for example, 0.1% or more, preferably 0.05% or more, and more preferably 0.01% or more.

According to the semiconductor storage device and the manufacturing method thereof of the modification, the same effects as those of the semiconductor storage device 1 and the manufacturing method thereof of the above-described embodiment are obtained.

### (Another modifications)

In the above-described embodiment and modification, the lower end of the pillar PL is ground and removed to provide the lower cap layer EP connected to the source line SL. However, the method of connecting the pillar and the source line is not limited thereto. For example, the lower end of the pillar may be caused to reach the source line, the memory layer may be removed from the side face of the pillar in the source line, and the pillar may be connected to the source line on the side face of the channel layer. In this case, since the pillar lower end is not ground and removed, the pillar after the crystalline channel layer is formed is maintained substantially as it is.

In the above-described embodiment and modification, the semiconductor storage device 1 includes the metal oxide nitride oxide silicon (MONOS) type memory cell MC including the charge storage layer CT and the like. However, even in a case where the semiconductor storage device includes a floating gate (FG) type memory cell including a floating gate and the like, the channel layers CN and CNp of the above-described embodiments and modification can be applied.

The FG-type memory cell includes a floating gate between control gates as a plurality of conductive layers, the floating gate being electrically floating from the control gates. The floating gate is sandwiched between a tunnel insulating layer provided at the channel layer and an inter-control gate insulating layer provided opposite to the tunnel insulating layer, and charges are accumulated in the floating gate, so that data can be held. As described above, the FG type memory cell also has a structure in which the sidewall of the channel layer is covered with the multi-layered insulating layer of the tunnel insulating layer including the floating gate as the charge storage layer and the inter-control gate insulating layer.

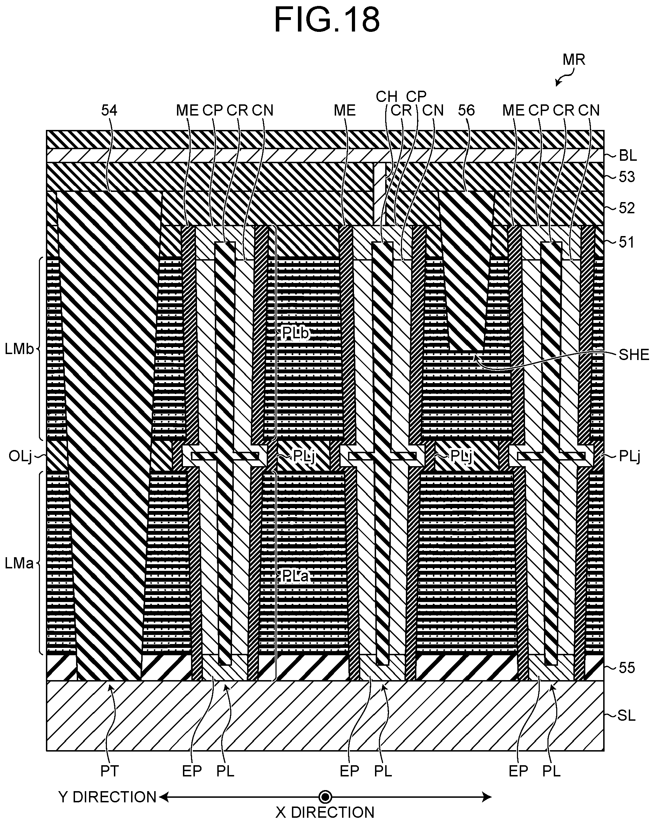

In addition, in the above-described embodiment and modification, the semiconductor storage device 1 includes the stacked body LM having one tier. However, by stacking a plurality of stacked bodies LMs, the semiconductor storage device may include the stacked body LM having two or more tiers. In this case, since the memory holes MH and the like can be formed for each tier, the final number of stacked bodies LM can be increased. Fig. 18 below illustrates a configuration example of a semiconductor storage device including two tiers of stacked bodies LMa and LMb.

Fig. 18 is a cross-sectional view illustrating an example of a configuration of a semiconductor storage device according to another modification of the embodiment.

As illustrated in Fig. 18, the semiconductor storage device of another modification includes a stacked body LMa disposed on the source line SL via the insulating layer 55 and a stacked body LMb disposed on the stacked body LMa via the insulating layer OLj. In this case, the drain-side selection gate line SGD is included in the stacked body LMb on the upper layer side, and is disposed further on the uppermost word line WL of the stacked body LMb. In addition, the source-side selection gate line SGS is included in the stacked body LMa on the lower layer side, and is disposed further on the lowermost word line WL of the stacked body LMa.

The pillar PL extending in the stacking direction of the stacked bodies LMa and LMb includes a pillar PLa that penetrates the stacked body LMa and the insulating layer 55 and reaches the source line SL, and a pillar PLb that penetrates the insulating layer 52 and the stacked body LMb and reaches an insulating layer OLj. The upper end of the pillar PLa and the lower end of the pillar PLb corresponding to each other are connected via, for example, a joint PLj disposed in the insulating layer OLj. The joint PLj has a cross-sectional area and a diameter along the XY plane larger than the cross-sectional area and the diameter of the other portion of the pillar PL.

The semiconductor storage device of another modification illustrated in Fig. 18 is manufactured as follows, for example.

That is, a stacked body to be the stacked body LMa by replacement is formed on the insulating layer 55, the insulating layer OLj that covers the stacked body is formed, a memory hole that penetrates the insulating layer OLj, the stacked body, and the insulating layer 55 and reaches the source line SL is formed, and the diameter of the memory hole in the insulating layer OLj is enlarged. As a result, portions to be the pillar PLa and the joint PLj later are formed.

In addition, a stacked body to be the stacked body LMb by replacement is formed on the insulating layer OLj, the insulating layer 52 covering the stacked body is formed, and a memory hole penetrating the insulating layer 52 and the stacked body and connected to the enlarged diameter portion in the insulating layer OLj of the memory hole formed in the lower stacked body is formed. As a result, a portion to be the pillar PLb later is formed.

As described above, by enlarging the diameter of the upper end of the memory hole on the lower layer side, the memory holes on the upper and lower layers can be more reliably connected even if the memory hole on the upper layer side is formed in a slightly misaligned state.

The processing illustrated in Figs. 7A to 11F of the above-described embodiment is performed on the memory hole penetrating the entire stacked body of the upper and lower layers via the enlarged diameter portion in the insulating layer OLj to form the pillar PL. However, the crystallization of the amorphous channel layer CNs may be performed by the MIC annealing treatment of Figs. 16A to 17C of the above-described modification instead of the MILC annealing treatment of Figs. 7A to 7C and Figs. 9A to 9C described above.

As described above, in the method of manufacturing the semiconductor storage device including the stacked body having the plurality of tiers, the memory hole is formed for each tier, and the memory layers ME, the channel layers CN, the core layers CR, and the like in the memory holes is collectively formed after the formation of the memory holes penetrating entirely the plurality of tiers.

Thereafter, as in the above-described embodiment, by performing the processing in and after Fig. 12A, the semiconductor storage device of another modification is manufactured.

As described above, the joint PLj of the pillar PL is formed in order to secure the positional deviation margin of the memory holes of the upper and lower layers. However, in a case where the alignment accuracy of the memory holes in the upper and lower layers is sufficiently high, the upper end of the memory hole in the lower layer does not need to be enlarged in diameter, and in this case, even the pillar PL having the multi-tier structure does not need to have the joint PLj.

In addition, in the above-described embodiment and modification, the contact region ER is disposed at the end of the stacked body LM in the X direction. However, the contact region ER may be disposed at the center of the stacked body LM in the X direction. In this case, the memory regions MR can be disposed on both sides of the contact region ER in the X direction. In addition, instead of disposing the plurality of contacts CC connected to the plurality of word lines WL collectively in the contact region ER, the contacts CC may be disposed to be dispersed in the memory region MR or the like.

In the above-described embodiment and modification, the peripheral circuit CBA is disposed above the stacked body LM. However, the peripheral circuit may be disposed below the stacked body or in the same layer as the stacked body.

In a case where the peripheral circuit is disposed below the stacked body, for example, the source line and the stacked body can be formed on an insulating layer of the semiconductor substrate having the peripheral circuit covered with the insulating layer. When the peripheral circuit is disposed in the same layer as the stacked body, the stacked body can be formed at a position different from that of the peripheral circuit on the semiconductor substrate on which the peripheral circuit is formed.

Various embodiments are in accordance with the following numbered clauses.

Clause 1. A semiconductor storage device (1) comprising:
a stacked body (LM) including a plurality of conductive layers (WL, SGD, SGS) and a plurality of insulating layers (OL) alternately stacked; and
a plurality of pillars (PL) each including a core material (CR) extending in the stacked body (LM) in a first direction intersecting a face of each of the plurality of conductive layers (WL, SGD, SGS), a semiconductor layer (CN) covering a side face of the core material (CR), and a multi-layered insulating layer (ME) stacked on a side face of the semiconductor layer (CN), the semiconductor layer (CN) being crystalline, the multi-layered insulating layer (ME) including a charge storage layer (CT), wherein
each of the semiconductor layers (CN) includes
a crystal structure in which the appearance number of crystal grain boundaries per 1 µm in the first direction is less than 2 near to at least a first end in the first direction, and
an additive that includes one or more of carbon, nitrogen, oxygen, and fluorine.

Clause 2. The semiconductor storage device (1) according to clause 1, wherein
the semiconductor layer (CN) includes a crystal structure in which the appearance number of crystal grain boundaries per 1 µm in the first direction is less than 0.5 near to the first end.

Clause 3. The semiconductor storage device (1) according to clause 1 or 2, wherein
in a layer thickness direction of the semiconductor layer (CN), a concentration of the additive increases from the multi-layered insulating layer (ME) toward the core material (CR).

Clause 4. The semiconductor storage device (1) according to any of clauses 1 to 3, wherein
the semiconductor layer (CN) includes a metal element that includes one or more of nickel, palladium, and aluminum.

Clause 5. The semiconductor storage device (1) according to any of clauses 1 to 4, wherein the additive is carbon.

Clause 6. The semiconductor storage device (1) according to any of clauses 1 to 5, wherein
the plurality of pillars (PL) includes first pillars (PL), the first pillars (PL) each including the semiconductor layer (CN) with an average grain size decreasing from the first end in the first direction toward a second end opposite the first end.

Clause 7. The semiconductor storage device (1) according to clause 6, wherein
an average grain size of the semiconductor layer (CN) included in each of the first pillars (PL) is
1 µm or more near to the first end, and
5 nm or more and 100 nm or less near to the second end.

Clause 8. The semiconductor storage device (1) according to clause 6 or 7, wherein
the semiconductor layer (CN) included in each of the first pillars (PL) includes a crystal structure in which the appearance number of crystal grain boundaries per 1 µm in the first direction is 10 or more near to the second end.

Clause 9. The semiconductor storage device (1) according to clause 8, wherein
a ratio of the first pillars (PL) included in the plurality of pillars (PL) is 4% or less.

Clause 10. A semiconductor storage device (1) comprising:
a stacked body (LM) including a plurality of conductive layers (WL, SGD, SGS) and a plurality of insulating layers (OL) alternately stacked; and
a plurality of pillars (PL) each including a core material (CR) extending in the stacked body (LM) in a first direction intersecting a face of each of the plurality of conductive layers (WL, SGD, SGS), a semiconductor layer (CN) covering a side face of the core material (CR), and a multi-layered insulating layer (ME) stacked on a side face of the semiconductor layer (CN), the semiconductor layer (CN) being crystalline, the multi-layered insulating layer (ME) including a charge storage layer (CT), wherein
the semiconductor layer (CN) includes an additive that includes one or more of carbon, nitrogen, oxygen, and fluorine, and
a ratio of pillars (PL) in which a crystal grain boundary appears in the semiconductor layer (CN) among the plurality of pillars (PL) is less than 2% in a cross section in a direction intersecting the first direction when the cross section positions at a center of the plurality of pillars (PL) in the first direction.

Clause 11. A method of manufacturing a semiconductor storage device (1), the method comprising:
forming a stacked body (LMs) including a plurality of first insulating layers (NL) and a plurality of second insulating layers (OL) alternately stacked;
forming a plurality of holes (MH) extending in the stacked body (LMs) in a first direction intersecting a face of each of the plurality of first insulating layers (NL);
forming a multi-layered insulating layer (ME) including a charge storage layer (CT) and covering respective sidewalls of the plurality of holes (MH);
forming a first semiconductor layer (CNs) covering respective sidewalls of the plurality of holes (MH) with the multi-layered insulating layer (ME) interposed therebetween, the first semiconductor layer (CNs) being amorphous;
crystallizing the first semiconductor layer (CNs) by annealing treatment using metal assist to form a second semiconductor layer (CN), the second semiconductor layer (CN) being crystalline,;
filling, with a core material (CR), the plurality of holes (MH) surrounded by the second semiconductor layer (CN); and
when the first semiconductor layer (CNs) is formed, adding an additive that is one or more of carbon, nitrogen, oxygen, and fluorine to the first semiconductor layer (CNs) closer to the multi-layered insulating layer (ME) in a layer thickness direction of the first semiconductor layer (CNs).

Clause 12. The method of manufacturing the semiconductor storage device (1) according to clause 11, wherein
when the first semiconductor layer (CNs) is formed, the adding the additive includes adding the additive so that the additive has a peak concentration in a region where a distance from the multi-layered insulating layer (ME) is less than 50% of a layer thickness of the first semiconductor layer (CNs).

Clause 13. The method of manufacturing the semiconductor storage device (1) according to clause 12, wherein
when the first semiconductor layer (CNs) is formed, the adding the additive includes adding the additive so that the additive has the peak concentration in the region where the distance from the multi-layered insulating layer (ME) is 5% or more and less than 25% of the layer thickness of the first semiconductor layer (CNs).

Clause 14. The method of manufacturing the semiconductor storage device (1) according to clause 12 or 13, wherein
when the first semiconductor layer (CNs) is formed, the adding the additive includes adding the additive so that the peak concentration is 5×10¹⁹ atoms/cm³ or more and 1×10²¹ atoms/cm³ or less.

Clause 15. The method of manufacturing the semiconductor storage device (1) according to any of clauses 11 to 14, the method further comprising:
before filling the plurality of holes (MH) with the core material (CR), etching the second semiconductor layer (CN) in the layer thickness direction to make the second semiconductor layer (CN) thin.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the inventions. The accompanying claims are intended to cover such forms or modifications as would fall within the scope of the inventions.

## Claims

1. A semiconductor storage device (1) comprising:
a stacked body (LM) including a plurality of conductive layers (WL, SGD, SGS) and a plurality of insulating layers (OL) alternately stacked; and
a plurality of pillars (PL) each including a core material (CR) extending in the stacked body (LM) in a first direction intersecting a face of each of the plurality of conductive layers (WL, SGD, SGS), a semiconductor layer (CN) covering a side face of the core material (CR), and a multi-layered insulating layer (ME) stacked on a side face of the semiconductor layer (CN), the semiconductor layer (CN) being crystalline, the multi-layered insulating layer (ME) including a charge storage layer (CT), wherein
each of the semiconductor layers (CN) includes
a crystal structure in which the appearance number of crystal grain boundaries per 1 µm in the first direction is less than 2 near to at least a first end in the first direction, and
an additive that includes one or more of carbon, nitrogen, oxygen, and fluorine.

2. The semiconductor storage device (1) according to claim 1, wherein
the semiconductor layer (CN) includes a crystal structure in which the appearance number of crystal grain boundaries per 1 µm in the first direction is less than 0.5 near to the first end.

3. The semiconductor storage device (1) according to claim 1 or 2, wherein
in a layer thickness direction of the semiconductor layer (CN), a concentration of the additive increases from the multi-layered insulating layer (ME) toward the core material (CR).

4. The semiconductor storage device (1) according to any of claims 1 to 3, wherein
the semiconductor layer (CN) includes a metal element that includes one or more of nickel, palladium, and aluminum.

5. The semiconductor storage device (1) according to any of claims 1 to 4, wherein the additive is carbon.

6. The semiconductor storage device (1) according to any of claims 1 to 5, wherein
the plurality of pillars (PL) includes first pillars (PL), the first pillars (PL) each including the semiconductor layer (CN) with an average grain size decreasing from the first end in the first direction toward a second end opposite the first end.

7. The semiconductor storage device (1) according to claim 6, wherein
an average grain size of the semiconductor layer (CN) included in each of the first pillars (PL) is
1 µm or more near to the first end, and
5 nm or more and 100 nm or less near to the second end.

8. The semiconductor storage device (1) according to claim 6 or 7, wherein
the semiconductor layer (CN) included in each of the first pillars (PL) includes a crystal structure in which the appearance number of crystal grain boundaries per 1 µm in the first direction is 10 or more near to the second end.

9. The semiconductor storage device (1) according to claim 8, wherein
a ratio of the first pillars (PL) included in the plurality of pillars (PL) is 4% or less.

10. A semiconductor storage device (1) comprising:
a stacked body (LM) including a plurality of conductive layers (WL, SGD, SGS) and a plurality of insulating layers (OL) alternately stacked; and
a plurality of pillars (PL) each including a core material (CR) extending in the stacked body (LM) in a first direction intersecting a face of each of the plurality of conductive layers (WL, SGD, SGS), a semiconductor layer (CN) covering a side face of the core material (CR), and a multi-layered insulating layer (ME) stacked on a side face of the semiconductor layer (CN), the semiconductor layer (CN) being crystalline, the multi-layered insulating layer (ME) including a charge storage layer (CT), wherein
the semiconductor layer (CN) includes an additive that includes one or more of carbon, nitrogen, oxygen, and fluorine, and
a ratio of pillars (PL) in which a crystal grain boundary appears in the semiconductor layer (CN) among the plurality of pillars (PL) is less than 2% in a cross section in a direction intersecting the first direction when the cross section positions at a center of the plurality of pillars (PL) in the first direction.

11. A method of manufacturing a semiconductor storage device (1), the method comprising:
forming a stacked body (LMs) including a plurality of first insulating layers (NL) and a plurality of second insulating layers (OL) alternately stacked;
forming a plurality of holes (MH) extending in the stacked body (LMs) in a first direction intersecting a face of each of the plurality of first insulating layers (NL);
forming a multi-layered insulating layer (ME) including a charge storage layer (CT) and covering respective sidewalls of the plurality of holes (MH);
forming a first semiconductor layer (CNs) covering respective sidewalls of the plurality of holes (MH) with the multi-layered insulating layer (ME) interposed therebetween, the first semiconductor layer (CNs) being amorphous;
crystallizing the first semiconductor layer (CNs) by annealing treatment using metal assist to form a second semiconductor layer (CN), the second semiconductor layer (CN) being crystalline,;
filling, with a core material (CR), the plurality of holes (MH) surrounded by the second semiconductor layer (CN); and
when the first semiconductor layer (CNs) is formed, adding an additive that is one or more of carbon, nitrogen, oxygen, and fluorine to the first semiconductor layer (CNs) closer to the multi-layered insulating layer (ME) in a layer thickness direction of the first semiconductor layer (CNs).

12. The method of manufacturing the semiconductor storage device (1) according to claim 11, wherein
when the first semiconductor layer (CNs) is formed, the adding the additive includes adding the additive so that the additive has a peak concentration in a region where a distance from the multi-layered insulating layer (ME) is less than 50% of a layer thickness of the first semiconductor layer (CNs).

13. The method of manufacturing the semiconductor storage device (1) according to claim 12, wherein
when the first semiconductor layer (CNs) is formed, the adding the additive includes adding the additive so that the additive has the peak concentration in the region where the distance from the multi-layered insulating layer (ME) is 5% or more and less than 25% of the layer thickness of the first semiconductor layer (CNs).

14. The method of manufacturing the semiconductor storage device (1) according to claim 12 or 13, wherein
when the first semiconductor layer (CNs) is formed, the adding the additive includes adding the additive so that the peak concentration is 5×10¹⁹ atoms/cm³ or more and 1×10²¹ atoms/cm³ or less.

15. The method of manufacturing the semiconductor storage device (1) according to any of claims 11 to 14, the method further comprising:
before filling the plurality of holes (MH) with the core material (CR), etching the second semiconductor layer (CN) in the layer thickness direction to make the second semiconductor layer (CN) thin.
